(19) Europäisches Patentamt
European Patent Office
Office européen des brevets

(11) EP 2 223 750 B1

(12) # EUROPÄISCHE PATENTSCHRIFT

(45) Veröffentlichungstag und Bekanntmachung des Hinweises auf die Patenterteilung:
**13.04.2016 Patentblatt 2016/15**

(21) Anmeldenummer: **10163934.2**

(22) Anmeldetag: **06.11.2008**

(51) Int Cl.:
***B05C 3/18*** *(2006.01)*
***H01L 21/67*** *(2006.01)*
*B05C 3/20 (2006.01)*
*B05C 3/05 (2006.01)*
***H01L 21/00*** *(2006.01)*
*B05C 3/00 (2006.01)*
*B05C 9/14 (2006.01)*

(54) **Vorrichtung und Verfahren zur Beschichtung einer Oberfläche**

Device and method for coating a surface

Dispositif et procédé pour appliquer un revêtement sur une surface

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **07.11.2007 DE 102007053065**
**05.02.2008 DE 102008007570**

(43) Veröffentlichungstag der Anmeldung:
**01.09.2010 Patentblatt 2010/35**

(62) Dokumentnummer(n) der früheren Anmeldung(en) nach Art. 76 EPÜ:
**08848572.7 / 2 217 385**

(73) Patentinhaber: **Stangl Semiconductor Equipment AG**
**82256 Fürstenfeldbruck (DE)**

(72) Erfinder: **Eckstein, Jens**
**85221, Dachau (DE)**

(74) Vertreter: **Stöckeler, Ferdinand**
**Schoppe, Zimmermann, Stöckeler**
**Zinkler, Schenk & Partner mbB**
**Patentanwälte**
**Radlkoferstrasse 2**
**81373 München (DE)**

(56) Entgegenhaltungen:
**WO-A1-2007/093390**
**DE-A1- 2 917 943**
**FR-A1- 2 259 649**
**US-A- 5 298 288**
**WO-A1-2009/059770**
**DE-B3-102005 054 191**
**GB-A- 1 450 046**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 223 750 B1

## Beschreibung

Ausführungsbeispiele der vorliegenden Erfindung befassen sich mit einer Vorrichtung und einem Verfahren zur Beschichtung einer Oberfläche eines Gutes und beispielsweise damit, wie die Oberfläche eines kontinuierlich geförderten oder bewegten Gutes oder Materials beschichtet werden kann.

Beschichtungen von Materialien werden beispielsweise im Bereich der Halbleitererzeugung und -strukturierung häufig durchgeführt. Dabei ist es oft erforderlich, eine Schichtdicke über die gesamte Fläche der zu beschichteten Oberfläche möglichst homogen einstellen zu können. Bei in einzelnen Stücken vorliegenden Elementen kann eine Beschichtung leicht erfolgen, wenn, beispielsweise, ein Wafer, eine Folie oder Glasscheibe beziehungsweise ein zu beschichtendes Gut in seiner Gesamtheit in ein zur Beschichtung geeignetes Volumen, welches zumindest teilweise mit dem Beschichtungsmaterial gefüllt ist, getaucht wird oder mit diesem einseitig oder beidseitig in Kontakt gebracht wird. Die Beschichtung selbst kann dabei durch unterschiedliche Mechanismen beschleunigt bzw. ausgelöst werden. So ist es beispielsweise denkbar, eine aktivierende Chemikalie erst zuzugeben, wenn die zu beschichtenden Oberfläche bereits mit dem Beschichtungsmaterial in Kontakt ist. Chemikalien, deren Reaktionszeit kurz ist, die also schnell reagieren, können beispielsweise erst im Reaktionsvolumen selbst oder unmittelbar vor dem Einbringen in dasselbe oder erst auf der Oberfläche des zu beschichtenden Gutes miteinander gemischt werden.

In einigen Bereichen der Beschichtungstechnik und der Halbleitertechnik ist es darüber hinaus erforderlich, große zusammenhängende Oberflächen zu beschichten. Dies kann beispielsweise bei biegsamen Substraten, wie sie u.a. bei der Herstellung von organischen Halbleitern eingesetzt werden können, der Fall sein. Auch auf dem Gebiet der Solartechnik, in dem die hohen Produktionskosten von Solarzellen die erzielbaren Erträge oft übersteigen, kann es wünschenswert sein, eine Technologie zur Verfügung zu stellen, die die Beschichtung von Folien, bandförmigen Substraten oder Metallfolien ermöglicht, so dass in kurzer Zeit große Flächen beschichtet werden können, um so eine signifikante Reduzierung der Produktionskosten zu erreichen.

Die britische Patentanmeldung 1206106 zeigt eine Einrichtung zum Beschichten von bandförmigem Material, bei der das Material über Transportrollen in einer Flüssigkeit geführt wird.

Die US Anmeldung 5,795,625 befasst sich ebenfalls mit einer Vorrichtung zur Beschichtung von Stoffen mit einer Flüssigkeit. Das zu beschichtende Material wird mittels einer Walze durch ein Tauchbecken geführt, welches über eine Leitung mit der zur Beschichtung verwendeten Flüssigkeit befüllt wird. Unterhalb des Beckens befindet sich ein Vorratsvolumen für Wasser, welches dazu verwendet werden kann, die zur Beschichtung verwendete Flüssigkeit auf konstanter Temperatur zu halten.

Die US Anmeldung 3,762,190 befasst sich mit einer Vorrichtung zur Behandlung von Ledermaterialien, die mittels Transportrollen durch ein Flüssigkeitsbad geführt werden. Dabei befindet sich das Leder vollständig im Flüssigkeitsbad und wird so von beiden Seiten mit dem zur Beschichtung verwendeten Material in Verbindung gebracht. Die Flüssigkeit kann beheizt werden.

Die europäische Patentanmeldung 0038084 schlägt vor, eine zu beschichtende Folie nach der Beschichtung zu kühlen, um eventuelle durch Hitze hervorgerufene Knicke in der Beschichtung zu verhindern.

Die europäische Patentanmeldung 0608192 A1 schlägt vor, eine zur Galvanisierung verwendete Flüssigkeit (Zink) auf eine Temperatur von 400 - 500° zu erhitzen.

Die US Anmeldung 3,863,600 schlägt vor, die zur Beschichtung einer Oberfläche eines bandförmigen Materials verwendete Beschichtungslösung in einem externen Kreislauf zu temperieren.

Das Dokument US 5 298 288 A zeigt die Merkmale des Oberbegriffs von Anspruch 1.

Es besteht somit die Notwendigkeit, alternative und effizientere Konzepte zu entwickeln, um die Oberfläche eines Gutes zu beschichten.

Die Erfindung ist eine Vorrichtung nach Anspruch 1 und ein Verfahren nach Anspruch 10.

Bei einigen Ausführungsbeispielen der vorliegenden Erfindung wird es ermöglicht, eine Oberfläche eines Gutes zu beschichten, indem eine Transporteinrichtung verwendet wird, die die zu beschichtende Oberfläche des Gutes mit einer Flüssigkeit, welche die zur Beschichtung erforderlichen Reagenzien aufweist, in Kontakt bringt und an der Oberfläche vorbeiführt. Durch Variationen der Operationsparameter der Transporteinrichtung, wie beispielsweise des Vorschubs pro Zeiteinheit, kann erreicht werden, dass die zu beschichtende Oberfläche für eine vorbestimmte Zeit mit der Flüssigkeit in Kontakt bleibt, um eine Beschichtung derselben zu bewirken.

Durch Variation der Reaktionsparameter wie beispielsweise der Temperatur und der Konzentration der Reagenzien kann die Reaktionsgeschwindigkeit und in Kombination damit durch Variation der Kontaktzeit zwischen Material und Flüssigkeit die Schichtdicke der Beschichtung frei variiert werden. Die Variation der Kontaktzeit kann dabei bei einigen Ausführungsbeispielen von Transporteinrichtungen durch einfache Einstellung der Operationsparameter derselben erreicht werden.

Bei weiteren Ausführungsbeispielen der Erfindung wird das Gut von der Transporteinrichtung kontinuierlich und ohne Umkehr der Bewegungsrichtung an der Flüssigkeit vorbeigeführt bzw. durch ein Flüssigkeitsvolumen geleitet, so dass es möglich ist, kontinuierlich und ohne Unterbrechung die Beschichtung von ausgedehnten, beispielsweise bandförmigen, Materialien bzw. Gütern durchzuführen.

Bei weiteren Ausführungsbeispielen bzw. Systemen zur Beschichtung werden diese Materialien von einer Vorratsrolle zur Verfügung gestellt bzw. abgewickelt, um nach Beschichtung mittels der Transporteinrichtung bzw. nach Durchlauf der Transporteinrichtung auf einer Entnahmerolle empfangen und aufgerollt zu werden. Dies ermöglicht es, effizient und ohne Unterbrechung große Flächen bahnförmigen Materials zu beschichten.

Weitere Ausführungsbeispiele weisen eine Trockeneinrichtung auf, um das beschichtete Gut zu trocknen, so dass die Flüssigkeit der Beschichtung vollständig getrocknet ist, bevor das beschichtete Gut entnommen oder auf eine Entnahmerolle aufgewickelt wird, so dass die Qualität der Beschichtung nicht nach dem eigentlichen Beschichtungsvorgang durch etwaige mechanische Einflüsse verschlechtert wird. Die Ausführungsbeispiele der Erfindung weisen eine Heizeinrichtung auf, um die Oberfläche des zu beschichtenden Gutes und/oder die Flüssigkeit mit eventuellen chemischen Reagenzien zu heizen, so dass eine endotherme Reaktion ermöglicht wird oder um die Reaktionsgeschwindigkeit zu variieren. Dies erlaubt es beispielsweise, eine die Beschichtung auslösende bzw. das Beschichtungsmaterial bildende chemische Reaktion erst in unmittelbarem Kontakt mit der Oberfläche zu ermöglichen oder eine Reaktionsgeschwindigkeit derart zu erhöhen, dass eine durch die Beschichtung zu erzielende Schichtdicke bei gegebener Transporteinrichtung, also bei gegebener Vorschubgeschwindigkeit bzw. Relativgeschwindigkeit zwischen der Oberfläche des Gutes und der Flüssigkeit, erzielt wird.

Bei einigen Ausführungsbeispielen wird das zu transportierende Gut mittels einer zylindrischen Walze durch ein Flüssigkeitsbad geführt, wobei die Walze beheizt ist. Dabei kann die Geometrie der Transporteinrichtung so gewählt sein, dass das Gut entweder einseitig oder beidseitig beschichtet wird, d.h. also einseitig oder beidseitig mit der Flüssigkeit in Kontakt gerät. Bei weiteren Ausführungsbeispielen ist die Transporteinrichtung mit Dichtmitteln versehen, die es ermöglichen, denjenigen Oberflächenbereich des Gutes, der mit der Flüssigkeit in Kontakt gebracht wird, räumlich zu begrenzen. Dies können beispielsweise Dichtlippen sein, die am Rand eines bandförmigen Materials das Material gegenüber der Flüssigkeit abdichten, so dass es nur in einem zentralen, um die Symmetrieachse des Bandeszentrierten Bereichs zu einer Beschichtung des Materials bzw. des Gutes kommt.

Bei einigen weiteren Ausführungsbeispielen der Erfindung sind Transportrollen, die das Gut nach der Beschichtung bzw. nach der Transporteinrichtung führen, so konstruiert, dass diese einen Wasserfilm auf der Oberfläche der Transportrolle erzeugen, so dass eventuell noch nicht vollständig getrocknetes bzw. ausgehärtetes Beschichtungsmaterial durch die Transportrolle nicht von der Oberfläche des zu beschichtenden Gutes entfernt wird oder die Beschichtung beschädigt wird. Der Wasserstrom kann bei einigen Ausführungsbeispielen darüber hinaus dazu erwendet werden, eventuell vorhandene Verunreinigungen von der Oberfläche des beschichteten Guts zu spülen und dabei eventuell gleichzeitig einen berührungslosen Transport ermöglichen.

Einige Ausführungsbeispiele von Vorrichtungen zur Beschichtung werden nachfolgend, Bezug nehmend auf die beiliegenden Figuren, näher erläutert. Es zeigen:

| | |
|---|---|
| Fig. 1 | ein Ausführungsbeispiel einer Vorrichtung zur Beschichtung einer Oberfläche eines Guts; |
| Fig. 2 | ein weiteres Ausführungsbeispiel einer Vorrichtung zur Beschichtung einer Oberfläche; |
| Fig. 3 | ein weiteres Ausführungsbeispiel einer Vorrichtung zur Beschichtung einer Oberfläche mit Recyclingkreislauf; |
| Fig. 4a-4c | ein Ausführungsbeispiel zur einseitigen Beschichtung eines abgegrenzten Oberflächenbereichs eines bandförmigen Gutes; |
| Fig. 5a, 5b | ein weiteres Ausführungsbeispiel zur Beschichtung einer Oberfläche mit linearem Vorschub des zu transportierenden Gutes; |
| Fig. 6 | eine erfindungsgemäße Vorrichtung zur Beschichtung einer Oberfläche mit linearem Vorschub; |
| Fig. 7 | ein erfindungsgemäßes Ausführungsbeispiel mit linearem Vorschub und Heizmöglichkeit; |
| Fig. 8 | ein weiteres erfindungsgemäßes Ausführungsbeispiel mit linearem Vorschub und Dichtmitteln zur Begrenzung des beschichteten Oberflächenbereichs; |
| Fig. 9 | ein weiteres erfindungsgemäßes Ausführungsbeispiel mit linearem Vorschub; |
| Fig. 10 | ein weiteres Ausführungsbeispiel mit linearem Vorschub zur beidseitigen Beschichtung eines Gutes; |
| Fig. 11 | ein weiteres Ausführungsbeispiel zur beidseitigen Beschichtung; |
| Fig. 12 | ein Ausführungsbeispiel eines Verfahrens zur Beschichtung einer Oberfläche eines Gutes; |
| Fig. 13 | ein Ausführungsbeispiel eines Systems |

zum Beschichten eines bahnförmigen Gutes; und

Fig. 14a, b ein weiteres Ausführungsbeispiel mit bandförmigen zu beschichtendem Gut.

Fig. 1 zeigt ein Ausführungsbeispiel einer Vorrichtung zur Beschichtung einer Oberfläche eines Gutes, das geeignet ist, bahnförmiges Material zu beschichten.

In Fig. 1 ist die Vorrichtung schematisch in einer Schnittansicht dargestellt. Die Vorrichtung 1 weist dabei eine Transporteinrichtung 3 auf, um die zu beschichtende Oberfläche eines Gutes 4 (beispielsweise eines Materialbands) mit einer Flüssigkeit in Kontakt zu bringen und an der Flüssigkeit vorbei zu führen. Die Vorrichtung umfasst ferner einen Behälter 2, in dem sich die bereitgestellte Flüssigkeit befindet und eine Transportrolle 3, mittels derer das zu beschichtende Gut an der Flüssigkeit innerhalb des Behälters 2 vorbeigeführt wird. Im in Fig. 1 gezeigten Fall ist das zu beschichtende Gut 4 bandförmig, besitzt in einer Transportrichtung 5 also eine geometrische Ausdehnung, die die Ausdehnung des Bandes senkrecht zur Transportrichtung (die Breite des Bandes) bei weitem übersteigt. Das zu beschichtende Gut 4 kann dabei beispielsweise von einer Rolle mittels eines Abwicklers gewonnen und der Transporteinrichtung 3 zugeführt werden, wobei die zu beschichtende Oberfläche (die Gutseite) auf der der Transportrolle 3 abgewandten Seite befindlich ist. Durch eine Rotation der Transportrolle 3 (der Transporteinrichtung) wird das Gut 4 an der Flüssigkeit vorbeigeführt, bzw. durch das Flüssigkeitsvolumen, welches sich innerhalb des Behälters 2 befindet, transportiert.

Somit wird von der Transporteinrichtung 3 das zu beschichtende Gut 4 tangential zu der zu beschichtenden Oberfläche (der Gutseite) kontinuierlich bewegt, ohne dass eine Umkehr der Bewegungsrichtung stattfindet. Dies hat den Vorteil, dass das Material beschichtet werden kann, ohne den Vorschub des Gutes zu unterbrechen, so dass beispielsweise eine Rolle-zu-Rolle-Beschichtung von bandförmigen bzw. flexiblen Materialien wie beispielsweise Folien oder Metallbändern, ermöglicht wird.

Im in Fig. 1 gezeigten Fall wird das Gut in Transportrichtung 5 transportiert, so dass dieses beispielsweise einem nachfolgenden Aufwickler zugeführt werden kann, der das beschichtete Gut entgegennimmt und in Rollenform aufwickelt. Im Ausführungsbeispiel von Fig. 1 schließt sich an die Transporteinrichtung 1 ferner eine erste Umlenkrolle 6 und eine zweite Umlenkrolle 8 an, die dazu dienen, das bandförmige Gut zu führen. Bei einigen Ausführungsbeispielen kann die erste und/oder die zweite Umlenkrolle 6 oder 8 ausgebildet sein, um einen Wasserfilm auf der Oberfläche der Rolle bereitzustellen. Dies kann beispielsweise dadurch geschehen, dass die Führungsrolle eine zentrale Bohrung aufweist, in die Wasser mit vorbestimmtem Druck geleitet wird, so dass dieses durch eine Vielzahl von radialen Bohrungen in der Führungsrolle 6 auf den Außenumfang der Führungsrolle 6 strömt und dort zwischen dem zu transportierenden Gut 4 und der Führungsrolle 6 einen Wasserfilm bildet, welcher verhindert, dass die zu beschichtende Oberfläche des Gutes in unmittelbaren mechanischen Kontakt mit metallischen oder festen Teilen der Führungsrolle 6 kommen kann. Dies hat den Vorteil, dass, selbst wenn eine chemische Reaktion bzw. eine Beschichtungsreaktion oder ein Aushärten des zur Beschichtung verwendeten Materials bzw. der Flüssigkeit noch nicht vollständig erfolgt ist, eine qualitative Verschlechterung der Beschichtung durch mechanischen Kontakt mit starren oder festen Körpern verhindert werden kann.

Dabei ist zu bemerken, dass die Beschichtung von Folien oder Metallen oder ähnlichen bandförmigen Materialien mittels des in Figur 1 gezeigten Ausführungsbeispiels sowohl einseitig als auch zweiseitig möglich ist, je nachdem, ob das Gut 4 fluidisch dicht auf der Transportrolle 3 aufliegt, bzw. ob zwischen dem bandförmigen Gut 4 und der Transportrolle 3 Abdichtungsmaßnahmen getroffen sind, die verhindern, dass die Flüssigkeit auch auf die der zu beschichtenden Seite (der Gutseite) des Materials gegenüberliegenden Seite gelangen kann. Bezüglich der Materialeigenschaften des zu beschichtenden Gutes gibt es keine Einschränkungen. So kann eine zu beschichtende Folie bzw. ein bandförmiges Material beispielsweise aus Kunststoff, aus magnetischem oder nichtmagnetischem Material bestehen.

Im Falle einer einseitigen Beschichtung ist bei einigen Ausführungsbeispielen die erste Führungsrolle 6 ausgebildet, um einen Wasserfilm auf ihrer Oberfläche zu erzeugen, so dass die beschichtete Gutseite der Oberfläche nicht beschädigt wird. Wird das Material bzw. das Gut 4 beidseitig beschichtet, kann bei einigen Ausführungsbeispielen auch die zweite Führungsrolle 8 ausgebildet sein, um das Gut bzw. das Material auf einem Wasserfilm zu führen.

Bei einigen Ausführungsbeispielen wird die Vorschubgeschwindigkeit bzw. die Geschwindigkeit, mit der das Gut an der Flüssigkeit vorbei bewegt wird, derart eingestellt, dass sich die gewünschte Beschichtungsstärke ergibt. Dies kann sowohl durch vorher festgelegtes Design als auch durch eine Regelung erfolgen, so dass beispielsweise, wenn nach der Beschichtung festgestellt wird, dass die Schichtdicke zu gering ist, die Geschwindigkeit des Transports verringert werden kann. Bei einigen Ausführungsbeispielen wird dir Flüssigkeit im Gegenstrom zum zu beschichtenden Gut gefördert oder zirkuliert, das heißt also entgegen der Bewegungsrichtung des Guts. In diesem Fall ist gewährleistet, dass das Medium an der Kontaktstelle immer frisch ist.

Durch die Variation der Geschwindigkeit wird also die vorbestimmte Zeit, in der die Flüssigkeit mit der zu beschichteten Oberfläche des Gutes in Kontakt kommt, variiert. Bei einigen weiteren Ausführungsbeispielen kann entweder die Transportrolle 3 oder die Flüssigkeit bzw. der Behälter 2 oder beide im vorhergehenden genannten Einrichtungen beheizt sein, so dass eine Reaktionsgeschwindigkeit einer Chemikalie, die zur Beschichtung verwendet wird, erhöht wird oder dass eine endotherme Reaktion ermöglicht wird.

Eine geeignete Abstimmung der Temperatur bzw. der Transportgeschwindigkeit erlaubt es, die erzielbaren Schichtdicken zu wählen oder die Beschichtungsgeschwindigkeit geeignet einzustellen. Ein Beispiel für eine mögliche Beheizung der Transportrolle 3 ist in Fig. 1 unten in der perspektivischen Ansicht einer Transportrolle 3 gezeigt, die in Form eines Hohlzylinders ausgebildet ist, durch dessen Inneres eine zur Beheizung verwendete Flüssigkeit strömen kann. Dies kann beispielsweise ein Öl oder auch Wasser sein, wobei bei einigen Ausführungsbeispielen eine Flüssigkeit mit hoher Wärmekapazität verwendet wird, um eine gleichmäßige Beheizung sicherzustellen.

Sofern für die Beschichtung bzw. die chemische Reaktion, die an der Oberfläche des zu beschichtenden Gutes stattfinden soll, eine maximale Relativgeschwindigkeit zwischen dem zu beschichtenden Gut und der Flüssigkeit nicht überschritten werden darf, da die zur Beschichtung verwendeten Partikel sonst beispielsweise nicht mehr an der Oberfläche haften können, kann bei konstanter Rotationsgeschwindigkeit der Umfang der Transportrolle 3 variiert werden, bzw. die Rotationsgeschwindigkeit kann bei konstantem Umfang verringert werden. Um einen guten Austausch der Flüssigkeit zu gewährleisten, wird bei einigen Ausführungsbeispielen die Flüssigkeit entgegen der Rotationsrichtung gefördert werden.

Zusätzlich zu den vorhergehend beschriebenen Heizmaßnahmen kann die Transportrolle 3 bei einigen Ausführungsbeispielen auch elektrisch beheizt sein. Ferner kann die Rolle oder das Gut auch mittels Strahlung beheizt werden, beispielsweise mittels Infrarotstrahlung. Das Material der Transportrolle 3 kann je nach zu transportierendem Gut oder gewünschter Wärmekapazität variiert werden. Beispielsweise können Metalle oder Metalllegierungen, Gläser oder Kristalline Substanzen verwendet werden.

Wie bereits oben erwähnt, lässt sich durch geeignete Anpassung des Durchmessers der Trommel und der Rotationsgeschwindigkeit das System auf die jeweils gegebenen Randbedingungen anpassen. Dies führt bei alternativen Ausführungsbeispielen auch dann zum Erfolg, wenn die Trommel nicht rotiert, sondern lediglich zur Definition des Weges des Gutes dient. Die kann beispielsweise der Fall sein, wenn das Gut über die Trommel 3 gleitet oder auf dieser auf einem Luft- oder Flüssigkeitskissen schwimmt.

Ist beispielsweise eine maximale Relativgeschwindigkeit zwischen zu beschichtendem Gut und Flüssigkeit von 1 mm/s vorgegeben und soll die gesamte Beschichtungsdauer 7 Minuten betragen, lässt sich der Trommeldurchmesser wie folgt abschätzen. Dabei wird als Arbeitshypothese davon ausgegangen, dass der Flüssigkeitsstand innerhalb des Behälters 2 so gewählt ist, dass 40% des Umfangs der Transportrolle 3 innerhalb der Flüssigkeit befindlich sind. Bei angenommener Relativgeschwindigkeit von 1 mm/s und 7 Minuten Beschichtungsdauer ergibt sich ein innerhalb der Flüssigkeit zurückzulegender Weg von 420 mm. Darüber hinaus ergibt sich aus der Tangentialgeschwindigkeit von 1 mm/s und dem wie folgt zu berechnenden Durchmesser der Trommel unmittelbar die Rotationsfrequenz derselben. Der Umfang der Trommel, der innerhalb der Flüssigkeit befindlich ist, muss 420 mm betragen. Da für den Radius r der Trommel gilt:

$$r = \frac{U}{2 \cdot \pi}$$

und darüber hinaus 40% des Umfangs 420 mm entsprechen (daraus ergibt sich für den vollen Umfang eine Länge von 1.050 mm), ergibt sich der erforderliche Radius der Transportrolle 3 zu:

$$r = \frac{1.050\,mm}{2 \cdot \pi} = 167\,mm$$

Eine Trommel eines Durchmessers von 334 mm erfüllt also die eingangs geforderten Bedingungen, wobei sich diese mit einer Frequenz dreht, die unmittelbar durch die maximale Relativgeschwindigkeit von 1 mm/s und dem Radius der Trommel vorgegeben ist.

Wird eine Relativgeschwindigkeit von 2 mm/s bei einer Beschichtungsdauer von 7 Minuten gefordert, würde sich durch Anwendung obiger Überlegungen eine Trommel doppelten Durchmessers, also mit d = 668 mm ergeben. Bei einer solchen Relativgeschwindigkeit würde sich eine Relativgeschwindigkeit von 120 mm/min ergeben. Folglich werden innerhalb der Flüssigkeit bzw. im Kontakt mit der Flüssigkeit in 7 Minuten Beschichtungszeit 840 mm Weg zurück gelegt, was mittels einer Trommel obiger Dimensionierung erreicht werden kann.

Figur 2 zeigt ein weiteres Ausführungsbeispiel einer Vorrichtung zur Beschichtung einer Oberfläche, wobei schematisch zusätzlich ein Mischer 10 gezeigt ist, der der Einrichtung zum Bereitstellen der Flüssigkeit (also dem Behälter 2) an einer Einbringposition 12 die Flüssigkeit bzw. die Chemikalien zuführt. An einer Ausbringposition 14, die in Form eines Überlaufs ausgebildet ist, verlässt die Flüssigkeit den Behälter 2, um in einem Auffangbehältnis 16 gesammelt zu werden. Die Flüssigkeit innerhalb des Auffangsbehältnisses 16 kann dabei gemäß einer Alternative als Abfall behandelt werden oder, wie es weiter unten noch näher ausgeführt wird, einer Rezirkulation zugeführt werden.

Der Mischer 10 kann beispielsweise eine Flüssigkeit, die aus mehreren Reagenzien besteht, im bereits vorgemischten Zustand bevorraten, um diese mit vorbestimmter Dosierungsgeschwindigkeit bzw. Menge dem Zulauf, also der Einbringposition 12 zuzuführen. Bei anderen Ausführungsbeispielen, bei denen eine möglicherweise vorzeitig stattfindende Reaktion der Reagenzien in der Flüssigkeit unerwünscht ist, kann der Mischer 10 die einzelnen Reagenzien getrennt bevorraten und erst unmittelbar vor der Zuführung zu der Einbringposition 12 mischen. Die Mischung kann prinzipiell auch innerhalb des Behälters 2 erfolgen, so dass bei weiteren Ausführungsbeispielen der Mischer 10 die einzelnen Reagenzien getrennt der Einbringposition zuführt. Soll beispielsweise eine Folie oder ein bandförmiges Material mit CdS, ZnS oder alternativen Materialien (Puffern) beschichtet werden, wie es bei der Produktion von Dünnschichtsolarzellen wünschenswert ist, können folgende Reagenzen in der Flüssigkeit enthalten sein: $CdSO_4$ THS und $NH_3$. Diese reagieren oberhalb einer Reaktionstemperatur chemisch, so dass sich auf der Oberfläche des Gutes 4 eine Schicht aus CdS abscheidet. Für die genannten chemikalischen Komponenten beträgt diese Reaktionstemperatur 53°C.

Um eine vorzeitige Reaktion und somit einen unnötigen Chemikalienverbrauch zu verhindern, können diese Chemikalien getrennt bevorratet werden, wobei die Bevorratung dann sowohl oberhalb der Reaktionstemperatur von 53°C als auch unterhalb derselben stattfinden kann. Wird die Bevorratung unterhalb der Reaktionstemperatur vorgenommen, können bei einigen Ausführungsbeispielen die Reagenzien auch bereits vermischt sein. Auch können Teile bereits vorgemischt bevorratet werden, beispielsweise $CdSO_4$ und $NH_3$, wobei deren Bevorratung kalt oder warm erfolgen kann, sofern THS getrennt zugegeben und dosiert wird.

Alternativ und/oder zusätzlich kann, wie oben beschrieben, die Transportrolle 3 beheizt werden, um eine Reaktion insbesondere an der Oberfläche der Transportrolle hervorzurufen. Dies kann zu einer Reduktion des Chemikalienverbrauchs führen, wenn im übrigen Volumen eine Reaktion der Chemikalien nicht oder nur mit verringerter Geschwindigkeit stattfindet, da die Reaktionstemperatur lediglich in unmittelbarer Umgebung der Rolle überschritten wird.

In der in Figur 2 gezeigten Ausschnittsvergrößerung ist erneut schematisch die Möglichkeit der Einzeldosierung dargestellt, bei der die unterschiedlichen Chemikalien (im illustrierten Beispiel THS, $CdSO_4$ und $NH_3$) einzeln bevorratet und der Einbringposition 12 zugeführt werden.

Wie es in der Ausschnittsvergrößerung zu sehen ist, werden die Chemikalien einzeln bevorratet und über geeignete Dosiermethoden an der Einbringposition 12 in den Behälter 2 gegeben. Die Förderung der Chemikalien bzw. Flüssigkeiten kann beispielsweise mittels Flügelrad- oder Dosierpumpen vorgenommen werden. Alternativ kann der Tank auch unter Druck gesetzt sein, so dass mittels getaktetem Öffnen und Schließen eines Ventils eine dosierte Förderung erfolgt. Im Förderweg bzw. vor der Einbringposition 12 kann ferner ein Mischer angebracht sein, der beispielsweise unter dem Einfluss der Schwerkraft, die einzelnen Komponenten mischt. Alternativ kann die Chemikalienzufuhr mittels eines Schwimmers geregelt werden, der die Menge der aus dem Vorratsbehältnis entfernte Flüssigkeit bestimmt, so dass diese prinzipiell auch unter dem Einfluss der Schwerkraft entnommen werden kann, sofern ein Ventil durch den Schwimmerstand geregelt wird.

Durch den geringen Chemikalienverbrauch lässt sich auch die Chemikalie im Spalt selbst unmittelbar nach dem Eintritt in den (Reaktor-) Spalt auf Prozesstemperatur heizen.

Bei dem in Figur 2 gezeigten Ausführungsbeispiel ist der Behälter 2 derart geformt, dass dieser eine innere Oberfläche aufweist, die der zu beschichtenden Oberfläche des Gutes 4 gegenüberliegt und deren Kontur an die Kontur der zu beschichtenden Oberfläche angepasst ist. Im dargestellten Fall ist also die innere Kontur des Behälters 2 kreisbogenförmig, so dass sich zwischen Transportrolle 3 und Innenwand des Behälters ein Spalt konstanter Breite ergibt. Eine geringe Breite dieses Spalts führt dazu, dass lediglich eine geringe gemischte Chemikalienmenge vorgehalten werden muss. Dies führt dazu, dass der Ausschuss, der proportional zum Volumen der bereits gemischten Chemikalie ist, minimiert werden kann. Darüber hinaus lässt sich das geringe Flüssigkeitsvolumen einfach beheizen, so dass ggfs. lediglich eine Beheizung der Transportrolle 3 erforderlich ist. Das Volumen, in dem die chemische Reaktion stattfindet, wird allgemein auch als Reaktor bezeichnet. Wird das Reaktorvolumen so weit wie möglich minimiert, führt dies, zusammengefasst, also dazu, dass lediglich ein geringer Medienverbrauch stattfindet, wobei das Medium zusätzlich nur wenig auskühlt, so dass in dem Spalt die Reaktor-Reaktion (die Spaltreaktion) effizient stattfinden kann.

Figur 3 zeigt ein weiteres Ausführungsbeispiel einer Vorrichtung zum Beschichten einer Oberfläche, in dem die Reaktion bzw. die Beschichtung in einem Spalt 20 zwischen dem zu beschichtenden Gut 4 und einer Kontur des Behälters 2 stattfindet. Die übrigen skizzierten Komponenten der Vorrichtung wurden bereits anhand von vorhergehenden Ausführungsbeispielen diskutiert, so dass die mit denselben Bezugszeichen versehenen Elemente aus Effizienzgründen im Folgenden nicht erläutert werden. Das in Figur 3 gezeigte Ausführungsbeispiel unterscheidet sich von dem in Figur 2 beschriebenen Ausführungsbeispiel dadurch, dass diese aus mehreren Heizelementen 30a-30d bestehende Heizeinrichtung 30 aufweist, um den Behälter 2 zu beheizen, und um sicherzustellen, dass die Flüssigkeit oder das Gemisch aus Reagenzien auf eine Temperatur erwärmt wird, bei der die zur Beschichtung gewünschte chemische Reaktion stattfinden kann. Figur 3 weist ferner eine zwischen der Ausbringposition 14 und der Einbringposition 12 angeordnete Einrichtung zum Zirkulieren der Flüssigkeit 40 auf, um die aus der Ausbringposition 14, d.h. aus dem Überlauf austretende Flüssigkeit, zumindest teilweise, wieder zu verwenden.

Die Einrichtung zum Zirkulieren der Flüssigkeit 40 weist eine Kühleinrichtung 42 und eine Filtereinrichtung 44 auf, die entlang einer Rückführrichtung 46 sequentiell hintereinander angeordnet sind. Die Kühleinrichtung dient dazu, das Chemikalien- bzw. Reagenzgemisch zu kühlen, um dieses wieder unterhalb eine zur Reaktion erforderliche Temperatur zu bringen, so dass während der Rezirkulation kein Chemikalienverbrauch stattfindet. Bereits reagiertes, beispielsweise kristallisiertes, Material wird mittels des Filters 40 aus den rezirkulierten bzw. recycelten Chemikalien- bzw. Flüssigkeitsstrom entfernt.

Somit ist es, zusätzlich zur Minimierung des Chemikalienverbrauchs durch eine Verringerung des Reaktorvolumens, möglich, den Gesamtverbrauch an Chemikalien bzw. Flüssigkeit zu verringern, indem die Flüssigkeit wieder aufbereitet und erneut verwendet wird. Bei dem in Figur 3 beschriebenen Ausführungsbeispiel kann bei einigen Ausführungsbeispielen die Chemikalie bzw. die Flüssigkeit permanent gekühlt und rezirkuliert werden. Bei kristallinen oder festen Bestandteilen in dem rezirkulierten Flüssigkeitsgemisch (beispielsweise CdS) kann die Flüssigkeit mit einer Zentrifuge gereinigt werden, um die CdS-Partikel/Kolloide abzuscheiden. Selbstverständlich kann alternativ zu dem in Figur 3 gezeigten Ausführungsbeispiel die Reaktorbeheizung auch von innen erfolgen, wobei die Heizelemente 30a-30d beispielsweise auch in den Behälter 2 integriert sein können. Zusätzlich und/oder alternativ kann wie in den vorhergehenden Ausführungsbeispielen beschrieben, die Transportrolle 3 beheizt werden.

Die Figuren 4a-4c zeigen in verschiedenen Ansichten ein Ausführungsbeispiel, bei dem der Oberflächenbereich des Gutes 4, der mit der Flüssigkeit in Kontakt gebracht wird, begrenzt ist, indem Dichtelemente 64 vorgesehen sind, die die Flüssigkeit von dem nicht in Kontakt zu bringenden Oberflächenbereich des Gutes 4 trennen. Dabei zeigt Figur 4a eine Ansicht des Ausführungsbeispiels, welches in Figur 4b in einer perspektivischen Ansicht dargestellt ist. In Figur 4c ist ferner eine Ausschnittsvergrößerung dargestellt, die es ermöglicht, die Dichtmechanismen zu erkennen, mittels derer der Oberflächenbereich, der mit der Flüssigkeit in Kontakt gebracht wird, begrenzt wird.

Das in den Figuren 4a-4c gezeigte Ausführungsbeispiel basiert dabei auf den bereits anhand der vorhergehenden Figuren diskutierten Ausführungsbeispielen, so dass in der folgenden Diskussion lediglich auf die Änderungen bezüglich dieser Ausführungsbeispiele eingegangen werden wird. Das in Figur 4 zu beschichtende Gut 4 wird derart transportiert bzw. bewegt, dass dieses einen zentralen Bereich 50 sowie einen Randbereich 52 aufweist, wobei lediglich der zentrale Bereich 50 mit der Flüssigkeit in Kontakt gebracht wird. Somit ist der zentrale Bereich 50 derjenige Oberflächenbereich des Gutes 4, der beschichtet wird. Die Flüssigkeit befindet sich in dem Behälter 2, innerhalb dessen die Transportrolle 3 verläuft. Um sicherzustellen, dass die Flüssigkeit lediglich im zentralen Bereich 50 mit dem Gut 4 in Kontakt kommt, ist eine Abdichtung vorgesehen, um das Gut 4 bzw. die Folie 4 zum Behälter 2 abzudichten.

In der in Figur 4 in einer Ansichtrichtung 56 dargestellten Ansicht des Ausführungsbeispiels der Figur 4b ist ersichtlich, dass die an Dichtungspositionen 60a und 60b angebrachten Dichtungen das Gut 4 bzw. die zu beschichtende Folie 4 in den zentralen Bereich 50 und den Randbereich 52 unterteilen. In dem zentralen Bereich 50 wird die Flüssigkeit mit der Oberfläche des Gutes 4 in Kontakt gebracht, wohingegen in dem Randbereich 52 die Oberfläche des Gutes nicht mit der Flüssigkeit bzw. dem Chemikaliengemisch in Kontakt gebracht wird. In der Ausschnittsvergrößerung des in Figur 4a umrahmten Bereichs 62, der in Figur 4c dargestellt ist, wird beispielhaft eine mögliche Form der Abdichtung gezeigt.

Dabei ist zwischen dem auf der Transportrolle 3 laufenden Gut 4 und dem Innenvolumen des Behälters 2, dessen eine Seitenwand schematisch dargestellt ist, ein Dichtmittel 64 angebracht, das ein freies Austreten der Flüssigkeit aus dem Inneren des Behälters 2 verhindert. Die Abdichtung kann dabei beispielsweise mittels einer Lippendichtung aus flexiblen Materialien, wie beispielsweise Kautschuk, CPDM oder Silikon vorgenommen werden. Alternativ dazu kann die Abdichtung auch mit beliebig anderen Dichtmitteln erfolgen, beispielsweise mittels eines Druckluftstroms, dessen Strömungsgeschwindigkeit derart groß ist, dass ein Austreten großer Mengen von Flüssigkeit verhindert werden kann. Bei alternativen Ausführungsbeispielen kann die Passung, also der Abstand zwischen Transportrolle und Behälter 2 so exakt erfolgt sein, dass sich bei Vorhandensein der Folie eine so geringe Spaltbreite ergibt, dass ein Flüssigkeitsaustritt nahezu vollständig verhindert wird. Dennoch austretende Flüssigkeit kann beispielsweise in einem Überlauf 66 aufgefangen werden, um diese eventuell einem Recycling zuzuführen. Weitere Ausführungsbeispiele können einen Gleitring bzw. eine Gleitring-Dichtung aus Kunststoff oder ähnlichen Materialien verwenden. Bei Verwenden von Kunststoff kann die gesamte Vorrichtung mit säurehaltigen Materialien gespült und gereinigt werden, wie beispielsweise mit HCl.

Die in den Figuren 5a und 5b gezeigten Ausführungsbeispiele zeigen jeweils Vorrichtungen zur Beschichtung einer Oberfläche mit linearem Vorschub, bei dem das Gut 4 näherungsweise eben bzw. plan relativ zur Flüssigkeit bewegt wird, so dass auch nicht flexible Materialien bzw. Materialien mit geringerer Flexibilität ein- oder zweiseitig beschichtet werden können. Bei dem in Figur 5a schematisch in einer Schnittansicht gezeigten Ausführungsbeispiel weist die Transporteinrichtung eine Transportrolle 3 auf, auf der das zu beschichtende Gut 4 läuft und die von einer idealen Zylindergeometrie abweicht und an ihren äußeren Randbereichen 70a, 70b einen sich vergrößernden Durchmesser besitzt. Dadurch wird das Material von der Transportrolle 3 in Form einer Rinne geführt. Die Transportrolle 3 befindet sich in dem in Figur 5a gezeigten Ausführungsbeispiel teilweise innerhalb eines Heizvolumens 72, das mit einer geeigneten Heizmethode (beispielsweise mit Heißluft oder (Infrarot)Strahlung beheizt werden kann. Die zu beschichtende Oberfläche bzw. die Gutseite des Guts 4 ist der Transportrolle 3 abgewandt und wird in einem zentralen Bereich 50 mit der Flüssigkeit bzw. dem Chemikaliengemisch in Kontakt gebracht und mittels der rotierenden Transportrolle 3 relativ zu dieser bewegt bzw. an dieser vorbeigeführt. Das in Figur 5a gezeigte Ausführungsbeispiel eignet sich für die einseitige Beschichtung eines Gutes bzw. eines bandförmigen Materials, wobei die Chemikalien bzw. die Flüssigkeit zugegeben bzw. zugemischt werden können, wie es bei einem der vorhergehenden Ausführungsbeispiele beschrieben ist. Das Ausführungsbeispiel weist ferner Dichtmittel 74a und 74b auf, um den Oberflächenbereich des Gutes 4, der mit der Flüssigkeit in Kontakt gebracht wird, zu begrenzen. So wird im in Figur 5a gezeigten Ausführungsbeispiel lediglich der zentrale Bereich 50 mit der Flüssigkeit in Kontakt gebracht.

Bei einigen alternativen Ausführungsbeispielen ist ferner die gesamte Apparatur um die Achse 82 gekippt, so dass unter dem Einfluss der Schwerkraft die Flüssigkeit auf der zu beschichtenden Oberfläche im zentralen Bereich 50 über die Oberfläche strömt bzw. fließt, so dass sich sowohl die Flüssigkeit als auch das Gut 4 bewegen. Um eine konstante Strömungsgeschwindigkeit der Flüssigkeit bzw. der Chemikalien zu erzielen, kann optional ein Stromstörer 84 verwendet werden, der innerhalb der Einrichtung zur Bereitstellung der Flüssigkeit, d.h. innerhalb des von den Dichtmitteln 74a und 74b begrenzten Volumens angeordnet ist.

Dabei kann, je nach Anforderung an die Apparatur, die Strömungsrichtung der Flüssigkeit beispielsweise parallel oder antiparallel zu der Vorschubrichtung bzw. der Bewegungsrichtung des Gutes oder der Folie 4 sein.

Figur 5b zeigt in einer perspektivischen Ansicht eine mögliche Implementierung der Transporteinrichtung 3 aus Fig. 5a. Im gezeigten Beispiel besteht diese aus zwei Rollen 86a und 86b, welche in einer Rotationsrichtung 88 rotieren, und somit das Gut in einer Transportrichtung 90 bewegen, so dass dieses beschichtet werden kann, wenn innerhalb der durch die Form der Transportrollen 86a und 86b gebildeten Rinne die zur Beschichtung verwendete Flüssigkeit bzw. das zur Beschichtung verwendete Chemikaliengemisch befindlich ist. Zusätzlich kann mittels eines Luftkissens der Transport unterstützt werden und/oder zusätzlich eine Heizung implementiert werden, wenn die Luft beheizt werden soll.

Figur 6 zeigt ein Ausführungsbeispiel der Erfindung mit linearem Vorschub des Gutes 4, das mittels zweier Führungsrollen 102 und 104 durch eine Prozessstrecke 108, geführt wird, die dazu dient, die Flüssigkeit bereitzustellen, innerhalb derer also sich die zur Beschichtung verwendete Flüssigkeit befindet. An der Einbringposition 12 werden die Chemikalien oder die Flüssigkeit eingebracht, die an der Ausbringposition 14, also an einem Auslauf, die Einrichtung 108 wieder verlassen.

Bei der in Fig. 6 gezeigten Schnittansicht eines Ausführungsbeispiels mit linearem Vorschub kann ein Winkel 112 ($\alpha$) zwischen der Horizontalen und der Apparatur bzw. dem Prozessbereich variiert werden, um eine Relativgeschwindigkeit zwischen der Flüssigkeit bzw. dem Chemikaliengemisch und dem zu beschichtenden Gut zu variieren. Dabei kann an der Eingangsseite 12 eine Abdichtungsmaßnahme vorgesehen sein, um ein ungewolltes Austreten der Chemikalien entgegen der Richtung der Bewegung des zu bewegenden Gutes zu verhindern. Dies kann beispielsweise mittels eines Luftmessers oder Mittels flexibler Dichtungen erreicht werden. Innerhalb der Prozessstrecke 108 kann das zu transportierende Gut 4 beispielsweise auf einer "Hot-Plate" 113 gelagert bzw. von einer solchen geführt sein, so dass das Gut zusätzlich beheizt werden kann. Bei einigen Ausführungsbeispielen wird die Hot-Plate beheizt. Dies kann beispielsweise durch eine in Kanälen 114 in der Hot-Plate 113 zirkulierende aufgeheizte Flüssigkeit erreicht werden. Bei weiteren Ausführungsbeispielen strömt ein Gas durch Bohrungen der Hot-Plate an die Unterseite des zu führenden Guts 4, so dass dieses auf einem Luftpolster schwebend durch die Prozessstrecke 108 geführt wird. Bei einigen Ausführungsbeispielen ist die in Fig. 6 gezeigte Anordnung bzw. die Prozessstrecke lediglich in Richtung des Winkels 112 rotierbar. Bei weiteren Ausführungsbeispielen kann die Proßessstrecke 108 in allen Raumrichtungen bewegt werden, so dass bei geeigneter Ansteuerung eine Taumelbewegung erzeugt wird, die die gleichmäßige Verteilung der Chemikalien auf der Oberfläche des zu beschichtenden Gutes sicherstellt. Damit kann insbesondere die Homogenität der Beschichtung verbessert werden. Bei weiteren Ausführungsbeispielen sind zusätzliche Durchmischungseinrichtungen angebracht, die sicherstellen, dass das Chemikaliengemisch permanent homogen durchmischt bleibt, so dass sich eine gleichmäßige Beschichtung ergibt. Bei einigen Ausführungsbeispielen der vorliegenden Erfindung wird dies durch einen oder mehrerer Ultraschallsender erreicht, die ein Ultraschallsignal in die Flüssigkeit abstrahlen, so dass die Molekülbewegung innerhalb der Flüssigkeit verstärkt wird und dadurch die Homogenität der Durchmischung verbessert wird.

Alternativ und/oder zusätzlich kann, wie bereits anhand einiger im Vorhergehenden diskutierter Ausführungsbeispiele erläutert, die Chemikalienmischung bzw. die Flüssigkeit permanent aufgefrischt bzw. regeneriert werden. Dies erfordert einen Austausch der Flüssigkeit auf der Oberfläche des zu transportierenden Gutes. Zu diesem Zweck kann die Flüssigkeit entweder in Transportrichtung des Gutes oder entgegen der Transportrichtung des Gutes geführt werden.

Wie bei den übrigen Ausführungsbeispielen ist es wünschenswert, dass die Materialien, die verwendet werden, um die mit dem zu transportierenden Gut in direktem Kontakt stehenden Bauteile zu bilden, resistent gegen die Verwendung der Chemikalien und gegen die auftretenden Temperaturen sind. Daher können die Materialien näherungsweise frei gewählt werden und an die verwendeten Chemikalien bzw. Prozesstemperaturen angepasst werden. Beispielsweise können die Materialien innerhalb der Prozessstrecke 108 bzw. der Transporttrommel 3 der vorhergehenden Ausführungsbeispiele aus Quarzglas oder VA-Stahl bestehen. Weitere mögliche Werkstoffe sind Kunststoffe und Metalle bzw. Metalllegierungen. Von Vorteil ist es, wenn diese mittels einer Säure gereinigt werden können, ohne zerstört zu werden.

Figur 7 zeigt einen Schnitt durch die in Figur 6 gezeigte Vorrichtung entlang einer Schnittebene 110. Das zu beschichtende Gut bzw. Material wird in einem zentralen Bereich 50 mit einer auf dem Gut 4 strömenden Flüssigkeit in Kontakt gebracht, wobei Dichtmittel 74a und 74b verhindern, dass ein signifikanter Bruchteil der Flüssigkeit den zentralen Bereich 50 verlassen kann. Bei einigen Ausführungsbeispielen wird ein Luftkissen zwischen einer sogenannten "Hot-plate" 114 und dem Gut erzeugt, auf dem das Gut transportiert wird. Bei weiteren Ausführungsbeispielen der Erfindung wird die im Luftstrom befindliche "Hot-plate" 114, die mit Bohrungen versehen ist und aus einem massiven Material besteht, beheizt, so dass die Luft von der "Hot-plate" 114 aufgeheizt wird und durch die Bohrungen ferner ermöglicht wird, dass sich zwischen der Hot-plate 114 und dem Gut 4 ein Luftfilm bildet. Durch das Verwenden der Hot-plate 114 kann auch eine Durchbiegung des Gutes 4 verhindert werden und es kann sichergestellt werden, dass die Temperatur näherungsweise konstant ist, wenn ein Material für die Hot-plate verwendet wird, welches eine hohe Wärmekapazität besitzt. Ein möglicherweise über die Dichtmittel 74a und 74b austretendes Chemikaliengemisch bzw. eine austretende Flüssigkeit kann mittels eines Überlaufbeckens 116 aufgefangen und eventuell recycled werden.

Figur 8 zeigt ein alternatives Ausführungsbeispiel mit linearer Führung des Gutes 4, bei dem die Dichtmittel 74a und 74b so ausgebildet sind, dass die Dichtwirkung durch einen Luftstrom erzielt wird. Zu diesem Zweck können, wie in Figur 8 gezeigt, die das Flüssigkeitsvolumen begrenzenden Seitenwände mit Luftbohrungen 120 versehen sein, durch die Luft oder ein beliebiges anderes Gasgemisch, das zur Dichtung verwendet werden kann, strömt. Die Strömungsgeschwindigkeit der Luft muss geeignet gewählt sein, so dass diese ermöglicht, ein Austreten der Flüssigkeit bzw. der Chemikalien an den Rändern der Dichtelemente 74a und 74b zu verhindern. Zur Heizung des Gutes 4 bzw. des zu beschichtenden Materials kann ferner eine Hot-plate verwendet werden, auf der, wie in Figur 9 schematisch dargestellt, ein Transportband verlaufen kann, welches wiederum den Transport des zu beschichtenden Gutes 4 sicherstellt, also die Transporteinrichtung bildet.

Figur 9 zeigt ein Ausführungsbeispiel eines solchen Transportbandes, bei dem sich im Inneren eine beispielsweise mittels einer Flüssigkeit durch Flüssigkeitskanäle 132 beheizte Hot-plate 134 befindet. Zwischen der Hot-plate 134 und dem zu transportierenden Gut 4, das im vorliegenden Fall in Form eines bandförmigen Materials vorliegt, befindet sich ein Luftkissen, mittels dessen das Gut 4 sowohl beheizt wird als auch vor mechanischer Beschädigung geschützt und mit ausreichendem Druck gegen die Dichtmittel 74a und 74b gepresst wird.

Die Figuren 10 und 11 zeigen Ausführungsbeispiele, mittels derer ein beidseitiges Beschichten eines Gutes 4 ermöglicht wird, wobei die beschichtete Oberfläche jeweils durch geeignete Dichtmittel 74a und 74b begrenzt wird, so dass die Transporteinrichtung die zu beschichtende Oberfläche lediglich in einem zentralen Bereich 50 in Kontakt mit der Flüssigkeit bringt.

Bei dem in Figur 10 gezeigten Ausführungsbeispiel wird das Gut bzw. das bandförmige Material 4 in einer Bewegungsrichtung 140 relativ zum Behälter 2 bewegt, innerhalb dessen sich die Flüssigkeit befindet. Das zu beschichtende Gut 4 wird dabei von Dichtlippen bzw. Dichtmitteln 74a und 74b sowohl mechanisch geführt als auch bezüglich des Behälters 2 abgedichtet, so dass eine sich in dem zentralen Bereich 50 befindliche Flüssigkeit bzw. eine dort eingebrachte Flüssigkeit zur Beschichtung diesen Bereich nicht verlassen kann, so dass auf jeder der beiden zu beschichtenden Oberflächenseiten lediglich ein begrenzter Oberflächenbereich, nämlich der zentrale Bereich 50, beschichtet bzw. mit der Flüssigkeit in Kontakt gebracht wird.

Der in Figur 11 gezeigte Fall entspricht prinzipiell dem in Figur 10 diskutierten Ausführungsbeispiel, wobei auch hier die Bewegungsrichtung 140 parallel zur Längsrichtung des Gutes bzw. des Materials ist. Der Förderweg ist jedoch nicht eben, sondern gekrümmt, so dass eine Abdichtung des Behälters 2 selbst unterbleiben kann, da das Gut entlang der Förderrichtung 140 zunächst in das innerhalb des Behälters 2 befindliche Flüssigkeitsvolumen getaucht und, aufgrund des krummen Förderwegs, aus diesem wieder entfernt wird.

Dies ermöglicht es, ohne aufwendige Dichtungsmaßnahmen beidseitig Materialien zu beschichten, welche die erforderliche Flexibilität für den gekrümmten Förderweg aufweisen.

Fig. 11 zeigt ferner optionale Ultraschallsender 142a, 142b und 142c, die innerhalb des Prozessvolumens 2 befindlich und mit diesem derart gekoppelt sind, dass diese Ultraschallleistungen die Flüssigkeit einstrahlen können. Dies dient dazu, die Homogenität der Durchmischung der Einzelkomponenten der Flüssigkeit zu verbessern, was insgesamt zu einer homogeneren Beschichtung des Guts bzw. der Folie führt.

Das zu beschichtende Gut 4 wird im in Fig. 11 gezeigten Fall von Führungsschienen 144a und 144b seitlich geführt, um den Förderweg einhalten zu können.

Selbstverständlich ist auch in Fig. 11 eine einseitige Beschichtung eines Gutes möglich, sofern die Führungsschienen 144a und 144b die bereits weiter oben beschriebenen Dichtungsmaßnahmen aufweisen, so dass eine Flüssigkeit beispielsweise nur oberhalb des zu beschichtenden Gutes 4 befindlich sein kann, und nur die Oberseite des Gutes 4 beschichtet wird.

Figur 12 zeigt ein Ausführungsbeispiel für ein Verfahren zum Beschichten einer Oberfläche eines Gutes.

Zunächst wird in einem Bereitstellungsschritt 200 eine Flüssigkeit bereitgestellt, welche die zur Beschichtung erforderlichen Reagenzien aufweist. In einem Vorschubschritt 202 wird eine zu beschichtende Oberfläche des Gutes mit der Flüssigkeit in Kontakt gebracht und an derselben vorbeigeführt, so dass die zu beschichtende Oberfläche für eine bestimmte Zeit mit der Flüssigkeit in Kontakt bleibt.

Durch das Vorbeiführen, bzw. die relative Bewegung zu dem zu beschichtenden Material bzw. Gut ist gewährleistet, dass eine kontinuierliche Beschichtung stattfinden kann, auch wenn Materialien beschichtet werden sollen, die in einer lateralen Richtung eine sehr große Ausdehnung besitzen, also beispielsweise bandförmig sind.

Bei einem anhand von Fig. 12 ebenfalls dargestellten alternativen Verfahren wird nach dem Bereitstellungsschritt 200 in einem Schritt 204 die Flüssigkeit am feststehenden Gut vorbeigeführt. Dies kann beispielsweise dazu verwendet werden, in einem diskreten Betrieb nicht kontinuierliche Materialien zu beschichten, wie beispielsweise Kunststoffplatten oder Glassubstrate oder Ähnliches.

Figur 13 zeigt ein Ausführungsbeispiel eines Systems zur Beschichtung eines bahnförmigen Gutes. Das in Figur 13 schematisch dargestellte System umfasst eine Vorrichtung zur Beschichtung einer Oberfläche 1, die einem der vorhergehenden ausführlich diskutierten Ausführungsbeispiele entsprechen kann, und die geeignet ist, eine Oberfläche eines Gutes 4 zu beschichten. Das System weist ferner eine Vorratsrolle 150 auf, die dazu dient, das zu beschichtende Gut zu bevorraten und das Gut für die Transporteinrichtung der Vorrichtung zur Beschichtung eines Gutes 1 bereitzustellen. Ferner weist das System eine Entnahmerolle 152 auf, um das beschichtete Gut von der Transporteinrichtung zu empfangen und um das beschichtete Gut zu bevorraten. Da es die Ausführungsbeispiele der Vorrichtungen zur Beschichtung einer Oberfläche eines Gutes erlauben, das Gut kontinuierlich an der zu beschichtenden Flüssigkeit vorbeizuführen, ist es mit dem in Figur 13 gezeigten System möglich, Materialien von "Rolle-zu-Rolle" zu beschichten, diese also kontinuierlich zu beschichten, ohne das Material in diskrete Stücke zerteilen zu müssen. Dies erhöht die Effizienz der Beschichtung und verringern die Beschichtungskosten signifikant.

Wie es in Fig. 13 dargestellt ist, ist es dabei günstig, ein Auf- und Abrollen des zu beschichtenden Guts auf der Vorratsrolle 150 bzw. auf der Entnahmerolle 152 so durchzuführen, dass die zu beschichtende Seite des Guts 4 (die Gut-Seite) jeweils auf den Durchmessern der Rollen nach außen zeigt. Dadurch wird zusätzliche Zeit zur Trocknung der Chemikalie an der Oberfläche der Gutseite 4 gewonnen, wenn diese an der Entnahmerolle 152 aufgerollt wird. Zusätzlich wird vermieden, dass die Gutseite, also die zu beschichtende Seite, in mechanischen Kontakt mit anderen Führungs- oder Umlenkrollen kommen kann, wenn eine Geometrie verwendet wird, wie sie in Fig. 13 gezeigt ist.

Mögliche weitere Umlenkrollen sind bei weiteren Ausführungsbeispielen der Erfindung vorgesehen. Sofern die Umlenkrollen die Gutseite berühren, verfügen diese bei einigen Ausführungsbeispielen entweder über eine Vorrichtung, um einen Flüssigkeitsfilm auf der Oberfläche der Umlenkrolle bereitzustellen oder um ein Luftpolster, auf dem das Gut schweben kann, zu erzeugen. So wird, selbst wenn eine Umlenkung in Richtung der Gutseite aus prozesstechnischen Gründen erforderlich wird, vermieden, dass die beschichtete Folie bzw. das beschichtete Gut qualitativ verschlechtert wird.

Figuren 14a und 14b zeigen ein weiteres Ausführungsbeispiel, bei dem, wie anhand der Figuren 1 bis 4 bereits diskutiert, das zu beschichtende Gut 4 um einen zylinderförmigen Körper 202 bzw. um ein Kreisbogensegment 204 geführt wird. Alternativ zum in den Figuren 1 bis 4 diskutierten Fall, in welchem die Trommel, um die das Gut 4 geführt wird, rotiert, ist es bei den in den Figuren 14a und 14b gezeigten Ausführungsbeispielen ferner möglich, dass die Trommel bzw. das Kreisbogensegment 204 starr angeordnet sind. Die übrigen Komponenten entsprechen den in den Figuren 1 bis 4 bereits diskutierten Komponenten, so dass auf eine erneute Diskussion dieser Teile an dieser Stelle verzichtet wird.

Mit anderen Worten bewegt sich bei den in den Figuren 14a und 14b gezeigten Ausführungsbeispielen lediglich das zu beschichtende Gut 4, die Trommel 202 bzw. das Kreisbogensegment 204 dient lediglich der Definition des Weges. Bei einigen Ausführungsbeispielen ist, um eine reibungslose Relativbewegung des zu beschichtenden Guts 4 zur Trommel 202 bzw. zum Kreisbogensegment 204 sicherzustellen, sowohl die Trommel 202 als auch das Kreisbogensegment 204 mit Bohrungen versehen, die es ermöglichen, ein mit Überdruck in der Trommel 202 bzw. dem Kreisbogensegment 204 befindliches Gas bzw. eine innerhalb der Komponenten befindliche Flüssigkeit austreten zu lassen, so dass das zu beschichtende Gut 4 auf einem Gas oder Flüssigkeitsfilm gleiten kann. Als Gas kann dabei beispielsweise $N_2$ oder Druckluft verwendet werden. Wird das Gas bzw. die Druckluft ferner geheizt, kann die Prozessgeschwindigkeit an der Oberfläche des zu beschichtenden Guts 4 erhöht werden bzw. es kann ein Prozess erst ermöglicht werden, falls dieser endotherm ist. Mit anderen Worten arbeitet das Gas zum einen als Transportmittel und zum anderen als Schutz bzw. Rückseitenprotektor für die der Flüssigkeit abgewandten Oberfläche des zu beschichtenden Guts 4. Dadurch wird ein einseitiges Beschichten ohne Randausschuss möglich, wenn der Luftdruck so groß ist, dass dieser an den Rändern des zu beschichtenden Gutes 4 verhindert, dass Flüssigkeit zwischen die Rückseite des zu beschichtenden Gutes und die Trommel 202 des Kreisbogensegments 204 gerät.

Die in Fig. 14a und 14b gezeigten Geometrien zur Führung des zu beschichtenden Guts 4 sind lediglich exemplarisch. Bei weiteren Ausführungsbeispielen werden daher unterschiedliche Geometrien des den Weg definierenden Elements (der Trommel 202 des Kreisbogensegments 204 bzw. der alternativen Ausführungsform) verwendet. Insbesondere kommen Elemente mit nicht-konstanter Krümmung, wie beispielsweise Ellipsoide oder dergleichen in Betracht. Auch bei diesen Ausführungsbeispielen ist es von Vorteil, wenn das Material, aus dem die Trommel gebildet ist, temperatur- und/oder säurebeständig ist, so dass die Apparatur leicht mittels Säure gereinigt werden kann bzw. bei andauernd hoher Prozesstemperatur keinen Schaden nimmt. Wie bereits oben diskutiert kommen hier beispielsweise Quarzglas oder PTFE als Materialien infrage, ohne dass diese Beispiele als abschließende Liste zu verstehen sein sollen.

Obwohl in den vorhergehenden Ausführungsbeispielen hauptsächlich Folien oder flexible Substrate beschichtet wurden, ist die Anwendung des beschriebenen Konzepts nicht auf solche Materialien beschränkt. Vielmehr können, insbesondere mit den Ausführungsbeispielen mit linearem Vorschub, auch nicht flexible Materialien beschichtet werden, wie beispielsweise Glas-Substrate, Halbleiter-Substrate oder sonstige mono- oder polykristalline Substrate und dergleichen Materialien.

Insofern eine schnelle Trocknung oder vollständige Trocknung der Beschichtung vor der Aufwicklung oder Weiterverarbeitung des beschichteten Gutes nicht ohne externe Maßnahmen erreicht werden kann, können weitere Ausführungsbeispiele zusätzlich eine Trockeneinrichtung aufweisen, mittels derer die Beschichtung auf der Oberfläche des zu beschichtenden Gutes getrocknet wird, bevor dieses weiterverarbeitet wird.

Die anhand der vorhergehenden Ausführungsbeispiele diskutierten Geometrien der ansprechenden Vorrichtungen sind lediglich beispielhaft zu verstehen und können beliebig an die Gegebenheiten angepasst werden, solange sichergestellt ist, dass das zu beschichtende Gut an der Flüssigkeit vorbeigeführt bzw. relativ zur Flüssigkeit bewegt wird.

Zusätzlich kann, wenn Umlenkrollen mit einem Wasserfilm oder Vakuumschlitten beziehungsweise Komponenten mit Luftpolster verwendet werden, ein zu transportierendes Band oder Gut ohne Berührung der Beschichtung annähernd beliebig umgelenkt werden. Werden die Rollen vorausgelenkt beziehungsweise mit vorbestimmter Kraft gegen das zu transportierende Gut gedrückt, kann darüber hinaus eine für einen faltenfreien Transport eines bandförmigen Materials erforderliche Bandspannung aufrechterhalten werden.

## Patentansprüche

1. Vorrichtung zur Beschichtung einer Oberfläche eines Gutes mit folgenden Merkmalen:

   einer Einrichtung zum Bereitstellen einer Flüssigkeit (2), die zur Beschichtung erforderliche Reagenzien aufweist;
   einer Transporteinrichtung (102, 104, 113; 130, 134), die ausgebildet ist, um eine Relativbewegung zwischen einer zu beschichtenden Oberfläche des Gutes (4) und der Flüssigkeit zu bewirken, während die zu beschichtende Oberfläche des Gutes mit der Flüssigkeit in Kontakt ist, so dass die zu beschichtende Oberfläche für eine vorbestimmte Zeit mit der Flüssigkeit in Kontakt bleibt, um eine Beschichtung derselben zu bewirken, wobei die Transporteinrichtung (3) ferner ausgebildet ist, um die Relativbewegung der zu beschichtenden Oberfläche, kontinuierlich und ohne Umkehr der Bewegungsrichtung (5) entlang einer beheizten Platte (113; 130; 134) zu bewirken,
   **dadurch gekennzeichnet, dass**
   die beheizte Platte (113; 130; 134) Bohrungen aufweist, die ausgelegt sind, um zwischen der beheizten Platte und dem Gut ein Luftkissen zu erzeugen, auf dem das Gut (4) transportiert wird, und

   wobei die Vorrichtung ausgelegt ist, um ein bandförmiges Gut (4) einseitig zu beschichten.

2. Vorrichtung nach Anspruch 1, die ferner Dichtmittel (74a, 74b) aufweist, die ausgelegt sind, um den Oberflächenbereich des Gutes, der mit der Flüssigkeit in Kontakt gebracht wird, zu begrenzen.

3. Vorrichtung nach Anspruch 2, bei der die Dichtmittel (74a, 74b) eine Lippendichtung, eine Gleitringdichtung oder eine Druckluft-Dichtung aufweisen.

4. Vorrichtung gemäss einem der vorhergehenden Ansprüche, bei der die Einrichtung zum Bereitstellen einer Flüssigkeit ferner eine Durchmischungseinrichtung aufweist, um eine Homogenität der Beschichtung des Gutes zu verbessern und/oder eine Einrichtung zum Erneuern und/oder Aufbereiten und/oder Zirkulieren der Flüssigkeit (40) aufweist.

5. Vorrichtung nach einem der vorhergehenden Ansprüche, bei der die Transporteinrichtung ausgebildet ist, um auf einer der Flüssigkeit abgewandten Seite des Gutes dieses auf einer Transportschicht eines Gases oder einer Flüssigkeit zu führen.

6. Vorrichtung nach einem der Ansprüche 1 bis 5, bei der die Einrichtung zum Bereitstellen (2) der Flüssigkeit eine Einbringposition (12) und eine von der Einbringposition (12) beabstandete Ausbringposition (14) für die Flüssigkeit aufweist, wobei die Transporteinrichtung (3) ausgebildet ist, um das Gut (4) von der Ausbringposition (14) der Flüssigkeit zu der Einbringposition (12) durch die Einrichtung zum Bereitstellen der Flüssigkeit zu transportieren.

**7.** Vorrichtung nach einem der Ansprüche 1 bis 6, die eine Führungsrolle (6) aufweist, die ausgebildet ist, um einen Wasserfilm auf einer Oberfläche derselben bereitzustellen, um eine beschichtete Oberfläche des Gutes (4) zu führen.

**8.** Vorrichtung nach einem der Ansprüche 1 bis 7, bei der die Transporteinrichtung ausgelegt ist, um das Gut (4) mit einer konstanten Geschwindigkeit zu bewegen, während die zu beschichtende Oberfläche mit der Flüssigkeit in Kontakt ist.

**9.** Vorrichtung nach einem der Ansprüche 1 bis 8, die ferner eine Trockeneinrichtung aufweist, um ein beschichtetes Gut (4) zu trocknen, sodass eine Beschichtung der zu beschichtenden Oberfläche getrocknet wird.

**10.** Verfahren zum einseitigen Beschichten einer Oberfläche eines bandförmigen Gutes mit folgenden Schritten:

Bereitstellen einer Flüssigkeit, die zur Beschichtung erforderliche Reagenzien aufweist; und
in Kontakt bringen des Gutes und der Flüssigkeit und erzeugen einer Relativbewegung zwischen einer zu beschichtenden Oberfläche des Gutes (4) und der Flüssigkeit, während die zu beschichtende Oberfläche des Gutes mit der Flüssigkeit in Kontakt ist, so dass die zu beschichtende Oberfläche für eine vorbestimmte Zeit mit der Flüssigkeit in Kontakt bleibt, um eine Beschichtung derselben zu bewirken, wobei die Relativbewegung der zu beschichtenden Oberfläche kontinuierlich und ohne Umkehr der Bewegungsrichtung (5) entlang einer beheizten Platte (113; 130; 134) bewirkt wird,

wobei die beheizte Platte (113; 130; 134) Bohrungen aufweist, die ausgelegt sind, um zwischen der beheizten Platte und dem Gut ein Luftkissen zu erzeugen, auf dem das Gut (4) transportiert wird

**11.** Verfahren nach Anspruch 10, bei dem das Gut mit einer konstanten Geschwindigkeit bewegt wird, während die zu beschichtende Oberfläche mit der Flüssigkeit in Kontakt ist.

**12.** Verfahren nach einem der Ansprüche 10 oder 11, das ferner ein Begrenzen des Oberflächenbereichs des Gutes, der mit der Flüssigkeit in Kontakt gebracht wird, aufweist.

**13.** Verfahren nach einem der Ansprüche 11 oder 12, bei dem das Gut eine Kunststofffolie oder eine Metallfolie ist, und bei dem die Oberfläche des Gutes mit CdS beschichtet wird.

**14.** System zum Beschichten eines bahnförmigen Gutes mit folgenden Merkmalen:

einer Vorrichtung (1) zur Beschichtung einer Oberfläche eines Gutes gemäss einem der Ansprüche 1 bis 9;
einer Vorratsrolle (150) zum Bevorraten des zu beschichtenden Gutes (4) und zum Bereitstellen des Gutes (4) für die Transporteinrichtung (3); und
einer Entnahmerolle (152) zum Empfangen des beschichteten Gutes von der Transporteinrichtung (3) und zum Bevorraten des beschichteten Gutes.

## Claims

**1.** A device for coating a surface of a product, comprising:

means for providing a liquid (2) comprising reagents required for coating;
transport means (102, 104, 113; 130, 134) configured to effect a relative movement between a surface of the product (4) to be coated and the liquid, while the surface of the product to be coated is in contact with the liquid such that the surface to be coated remains in contact with the liquid for a predetermined period of time so as to cause coating thereof, the transport means (3) further being configured to effect the relative movement of the surface to be coated continuously and without reversing the direction of movement (5) along a heated plate (113; 130; 134);
**characterized in that**
the heated plate (113; 130; 134) comprises bores implemented to generate an air cushion between the heated plate and the product on which the product (4) is transported; and

wherein the device is implemented to coat a band-shaped product (4) on one side.

**2.** The device in accordance with claim 1, further comprising sealing agents (74a, 74b) implemented to limit the surface region of the product which is contacted by the liquid.

**3.** The device in accordance with claim 2, wherein the sealing agents (74a, 74b) comprise lip sealing, slip ring sealing or compressed air sealing.

**4.** The device in accordance with one of the preceding claims, wherein the means for providing a liquid further comprises intermixing means in order to improve a homogeneity of the coating of the product and/or means for regenerating and/or treating and/or circulating the liquid (40).

**5.** The device in accordance with one of the preceding claims, wherein the transport means is configured to guide the product, on a side of the product facing away from the liquid, on a gas or liquid transport layer.

**6.** The device in accordance with one of claims 1 to 5, wherein the means for providing (2) the liquid comprises an introduction position (12) and a discharge position (14) for the liquid spaced apart from the introduction position (12), the transport means (3) being configured to transport the product (4) through the means for providing the liquid from the discharge position (14) of the liquid to the introduction position (12).

**7.** The device in accordance with one of claims 1 to 6, comprising a guiding roller (6) configured to provide a film of water on a surface thereof so as to guide a coated surface of the product (4).

**8.** The device in accordance with one of claims 1 to 7, wherein the transport means is implemented to move the product (4) at a constant rate, while the surface to be coated is contacted by the liquid.

**9.** The device in accordance with one of claims 1 to 8, further comprising drying means for drying a coated product (4) so that a coating of the surface to be coated is dried.

**10.** A method for one-sided coating of a surface of a band-shaped product, comprising:

providing a liquid comprising reagents required for coating; and
contacting the product and the liquid and generating a relative movement between a surface of the product (4) to be coated and the liquid, while the surface of the product to be coated is contacted by the liquid such that the surface to be coated remains in contact with the liquid for a predetermined period of time so as to effect coating thereof, the relative movement of the surface to be coated being effected continuously and without reversing the direction of movement (5) along a heated plate (113; 130; 134);

wherein the heated plate (113; 130; 134) comprises bores implemented to generate an air cushion between the heated plate and the product on which the product (4) is transported.

**11.** The method in accordance with claim 10, wherein the product is moved at a constant rate while the surface to be coated is in contact with the liquid.

**12.** The method in accordance with one of claims 10 or 11, further comprising limiting the surface region of the product which is contacted by the liquid.

**13.** The method in accordance with one of claims 11 or 12, wherein the product is a plastic foil or a metal foil and wherein the surface of the product is coated by CdS.

**14.** A system for coating a web-shaped product, comprising:

a device (1) for coating a surface of a product in accordance with one of claims 1 to 9;
a storage roller (150) for storing the product (4) to be coated and for providing the product (4) to the transport means (3); and
a withdrawal roller (152) for receiving the coated product from the transport means (3) and for storing the coated product.

## Revendications

**1.** Dispositif pour appliquer un revêtement sur une surface d'un produit, aux caractéristiques suivantes:

un moyen destiné à fournir un liquide (2) présentant des réactifs nécessaires pour le revêtement;
un moyen de transport (102, 104, 113; 130, 134) qui est réalisé pour provoquer un mouvement relatif entre une surface à revêtir du produit (4) et le liquide tandis que la surface à revêtir du produit est en contact avec le liquide, de sorte que la surface à revêtir reste pendant un temps prédéterminé en contact avec le liquide pour provoquer un revêtement de ce dernier, le moyen de transport (3) étant par ailleurs réalisé pour provoquer le mouvement relatif de la surface à revêtir en continu et sans inversion du sens de déplacement (5) le long d'une plaque chauffée (113; 130; 134),

**caractérisé par le fait que** la plaque chauffée (113; 130; 134) présente des alésages qui sont réalisés pour générer entre la plaque chauffée et le produit un coussin d'air sur lequel est transporté le produit (4), et

dans lequel le dispositif est réalisé pour recouvrir d'un côté un produit en forme de bande (4).

**2.** Dispositif selon la revendication 1, présentant par ailleurs des moyens d'étanchéité (74a, 74b) qui sont réalisés pour limiter la zone de surface du produit qui est amenée en contact avec le liquide.

**3.** Dispositif selon la revendication 2, dans lequel les moyens d'étanchéité (74a, 74b) présentent un joint d'étanchéité à lèvre, une garniture mécanique ou un joint d'étanchéité à air comprimé.

**4.** Dispositif selon l'une des revendications précédentes, dans lequel le moyen pour fournir un liquide présente par ailleurs un moyen de mélange destiné à améliorer une homogénéité du revêtement du produit et/ou un moyen pour renouveler et/ou traiter et/ou faire circuler le liquide (40).

**5.** Dispositif selon l'une des revendications précédentes, dans lequel le moyen de transport est réalisé pour guider, d'un côté opposé au liquide du produit, ce dernier sur une couche de transport d'un gaz ou d'un liquide.

**6.** Dispositif selon l'une des revendications 1 à 5, dans lequel le moyen pour fournir (2) le liquide présente une position d'entrée (12) et une position de sortie (14) du liquide, distante de la position d'entrée (12), dans lequel le moyen de transport (3) est réalisé pour transporter le produit (4) de la position de sortie (14) du liquide vers la position d'entrée (12) par le moyen destiné à fournir le liquide.

**7.** Dispositif selon l'une des revendications 1 à 6, présentant un rouleau de guidage (6) qui est réalisé pour fournir un film d'eau sur une surface de ce dernier, pour guider une surface revêtue du produit (4).

**8.** Dispositif selon l'une des revendications 1 à 7, dans lequel le moyen de transport est réalisé pour déplacer le produit (4) à une vitesse constante tandis que la surface à revêtir est en contact avec le liquide.

**9.** Dispositif selon l'une des revendications 1 à 8, présentant par ailleurs un moyen de séchage destiné à sécher un produit revêtu (4) de sorte que soit séché un revêtement de la surface à revêtir.

**10.** Procédé pour revêtir d'un côté une surface d'un produit en forme de bande, aux étapes suivantes consistant à:

fournir un liquide présentant des réactifs nécessaires pour le revêtement; et
mettre en contact le produit et le liquide et générer un mouvement relatif entre une surface à revêtir du produit (4) et le liquide tandis que la surface à revêtir du produit est en contact avec le liquide, de sorte que la surface à revêtir reste pendant un temps prédéterminé en contact avec le liquide pour provoquer un revêtement de ce dernier, le mouvement relatif de la surface à revêtir étant provoqué en continu et sans inversion du sens de déplacement (5) le long d'une plaque chauffée (113; 130; 134),

dans lequel la plaque chauffée (113; 130; 134) présente des alésages qui sont réalisés pour générer entre la plaque chauffée et le produit un coussin d'air sur lequel est transporté le produit (4).

**11.** Procédé selon la revendication 10, dans lequel le produit est déplacé à une vitesse constante tandis que la surface à revêtir est en contact avec le liquide.

**12.** Procédé selon l'une des revendications 10 ou 11, présentant par ailleurs le fait de limiter la zone de surface du produit qui est amenée en contact avec le liquide.

**13.** Procédé selon l'une des revendications 11 ou 12, dans lequel le produit est un film plastique ou un film métallique, et dans lequel la surface du produit est revêtue de CdS.

**14.** Système pour revêtir un produit en forme de bande, aux caractéristiques suivantes:

un dispositif (1) pour revêtir une surface d'un produit selon l'une des revendications 1 à 9;
un rouleau d'alimentation (150) destiné à alimenter le produit à revêtir (4) et mettre à disposition ledit produit (4) pour le moyen de transport (3); et
un rouleau de prélèvement (152) destiné à recevoir le produit revêtu du moyen de transport (3) et à alimenter le produit revêtu.

FIG 1

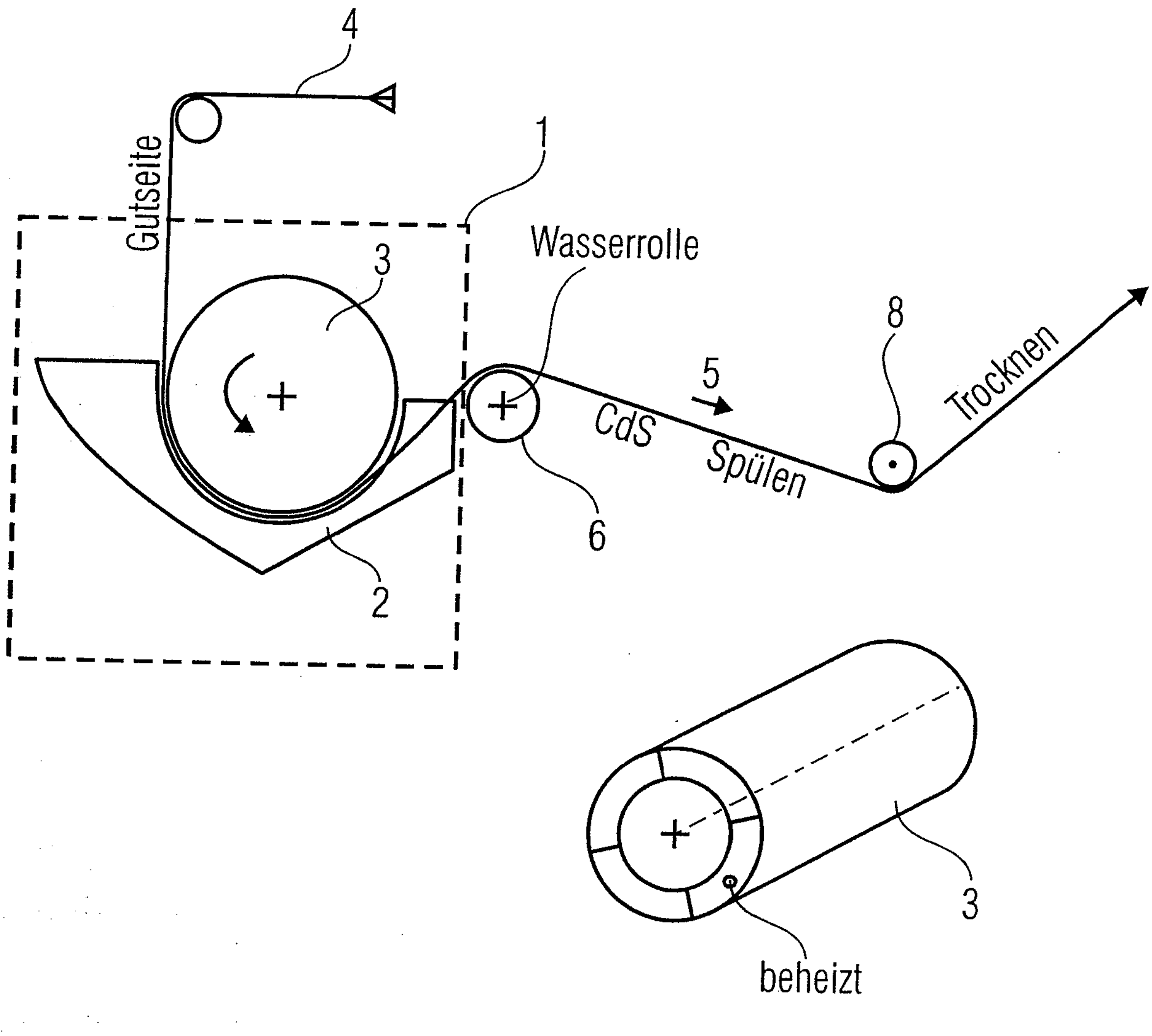
4
Gutseite
1
Wasserrolle
3
8
5
Trocknen
CdS
Spülen
6
2
3
beheizt

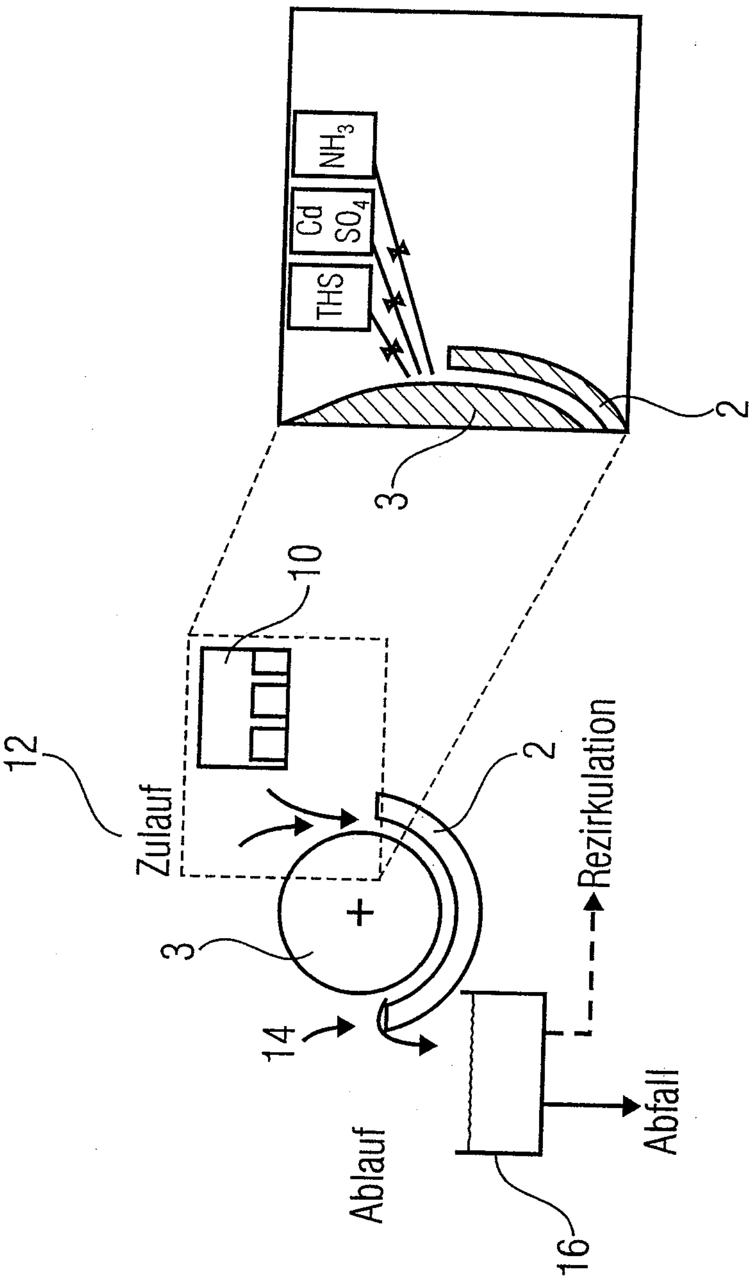
THS
Cd
SO4
NH3
2
3
10
12
Zulauf
2
Rezirkulation
3
14
Ablauf
Abfall
16

FIG 2

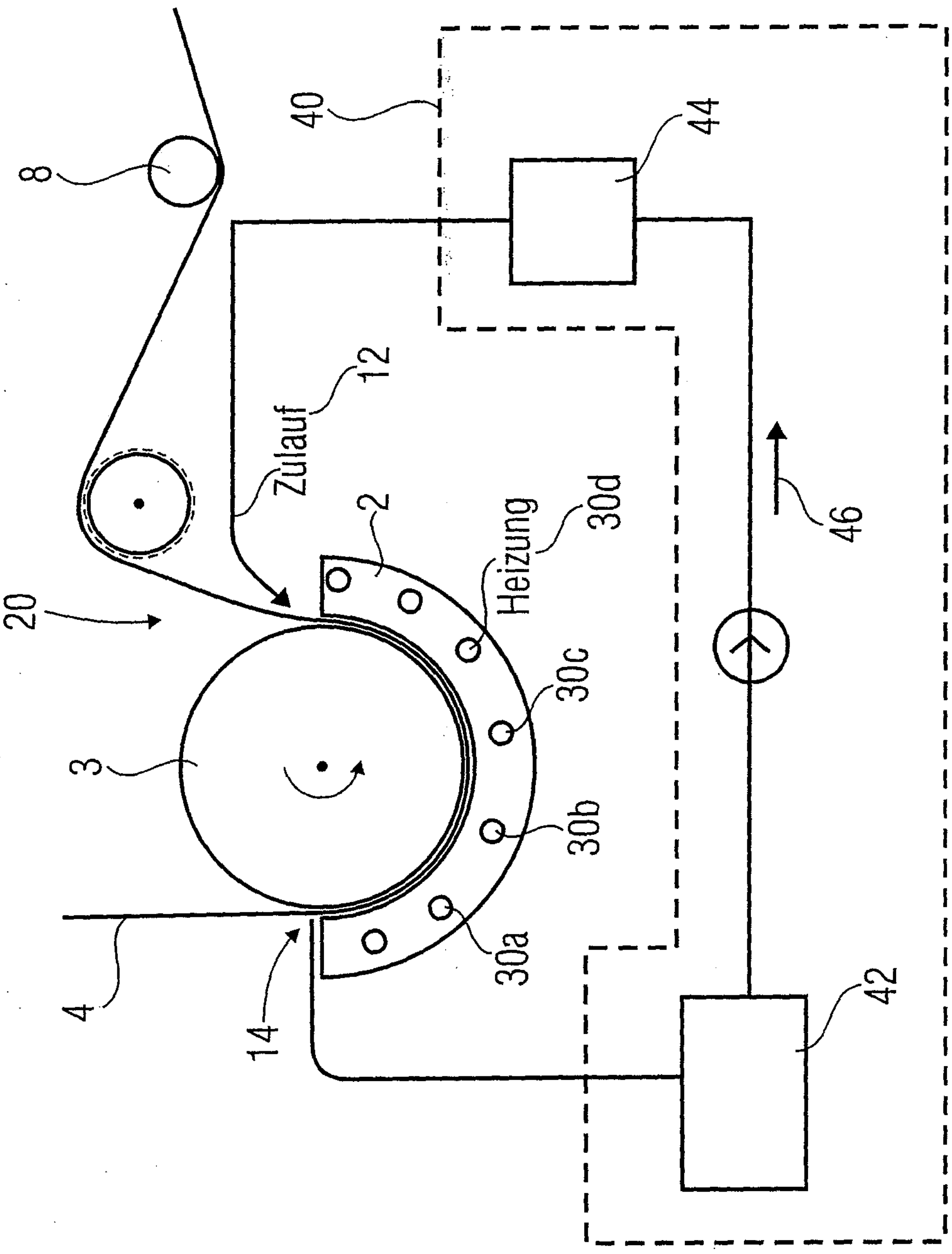


FIG 3

FIG 4A

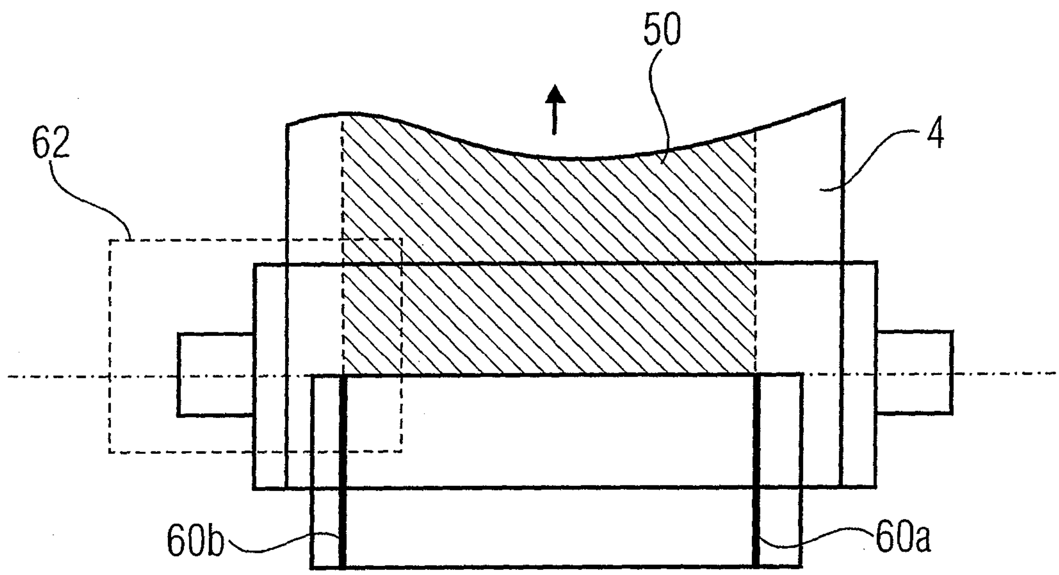


FIG 4B

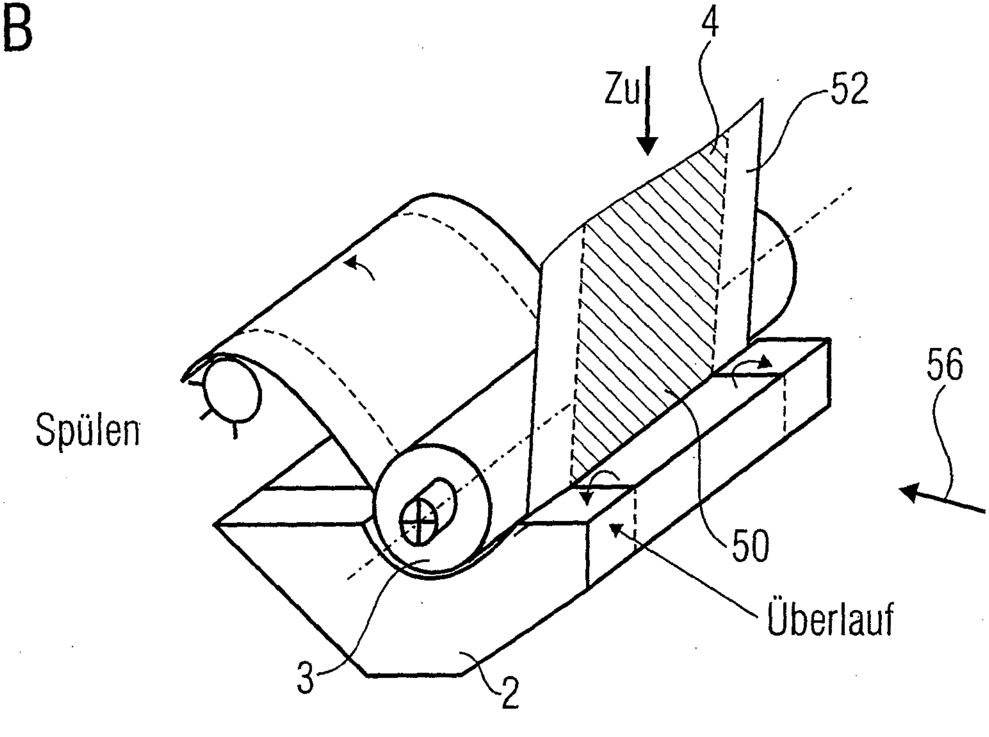

FIG 4C

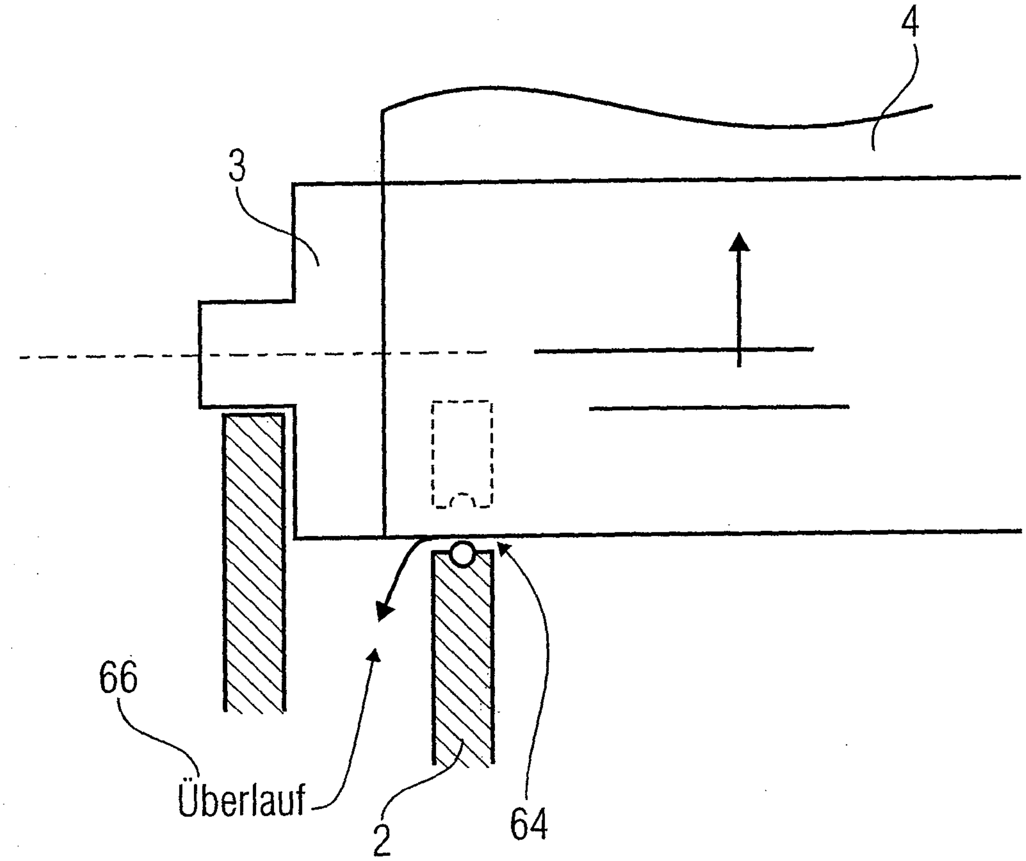

FIG 5A

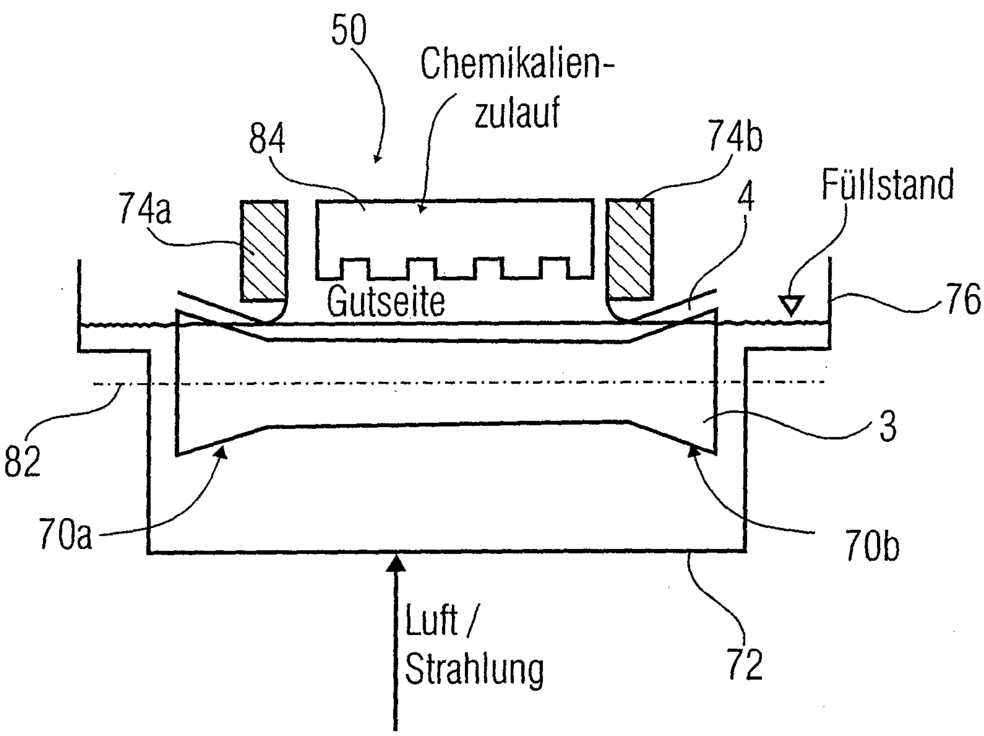
50
Chemikalien-
zulauf
84
74b
74a
4
Füllstand
Gutseite
76
82
3
70a
70b
Luft /
Strahlung
72

FIG 5B

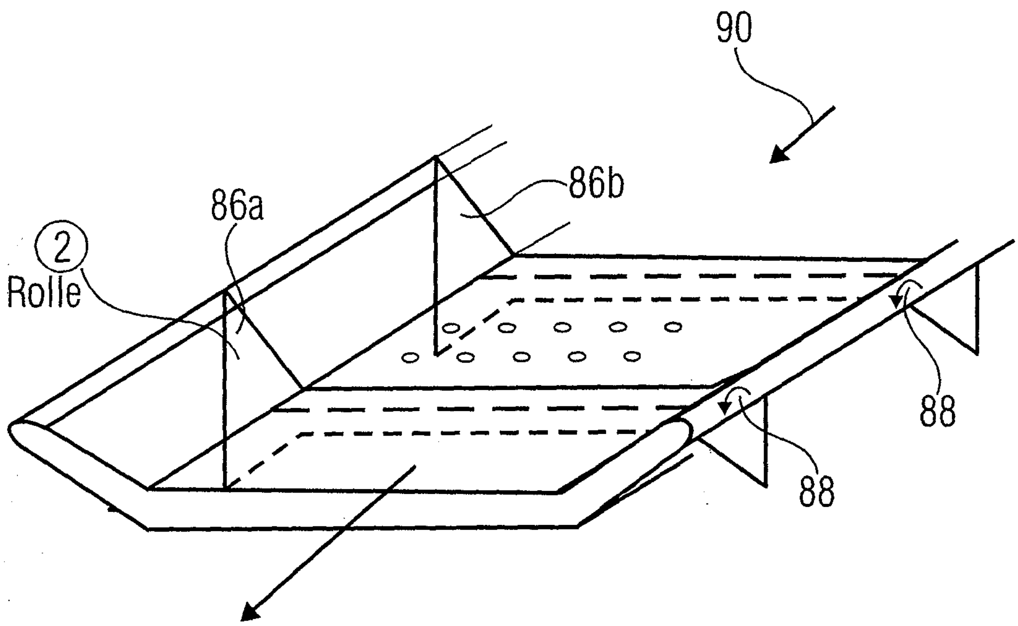
90
86b
86a
2
Rolle
88
88

FIG 6

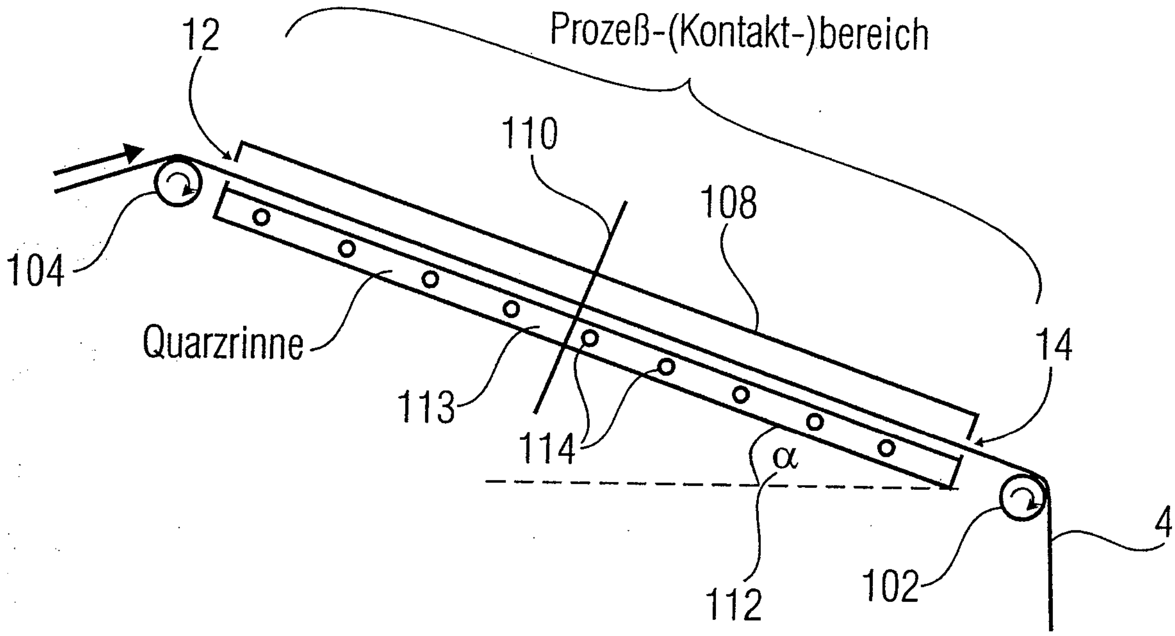
12
Prozeß-(Kontakt-)bereich
110
108
104
Quarzrinne
14
113
114
α
4
112
102

FIG 7

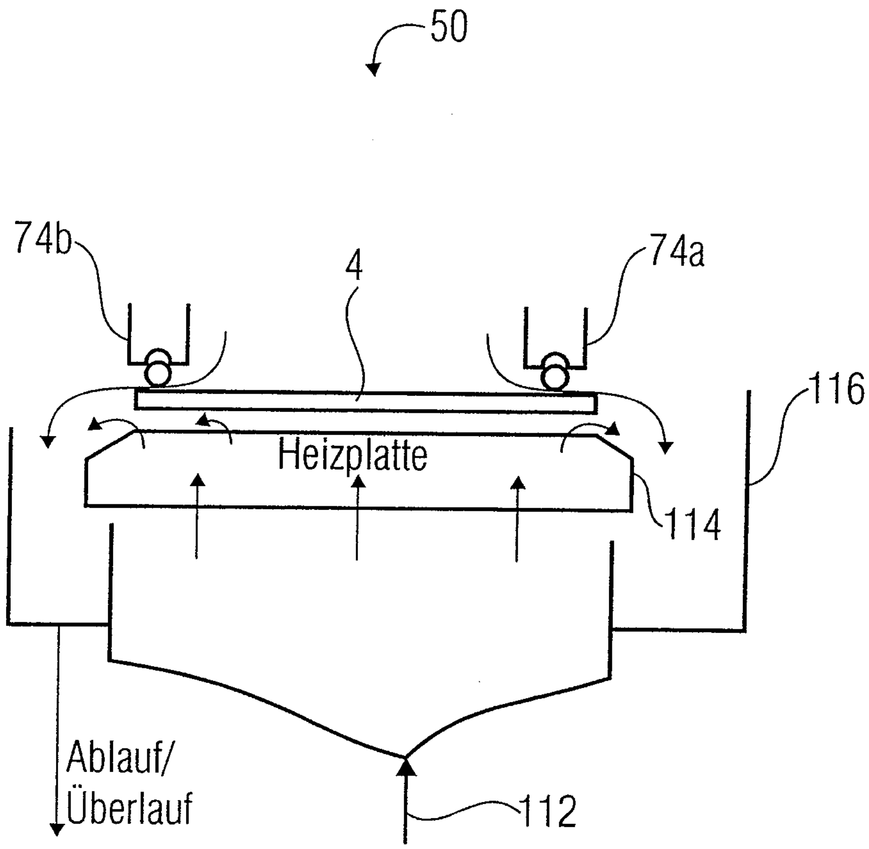

FIG 8

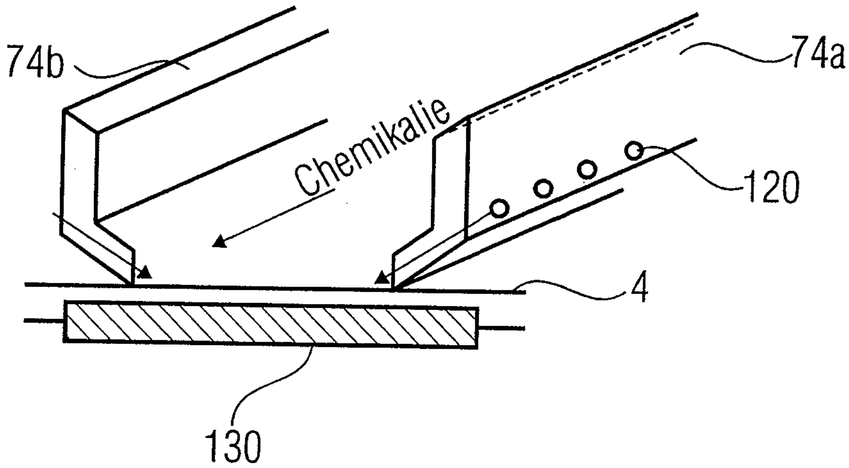
74b
74a
Chemikalie
120
4
130

FIG 9

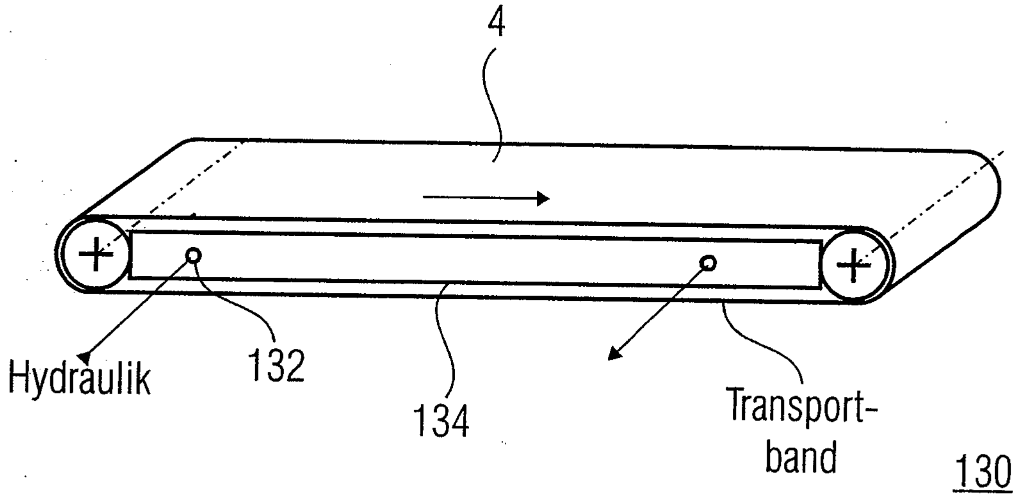
4
Hydraulik
132
134
Transport-
band
130

FIG 10

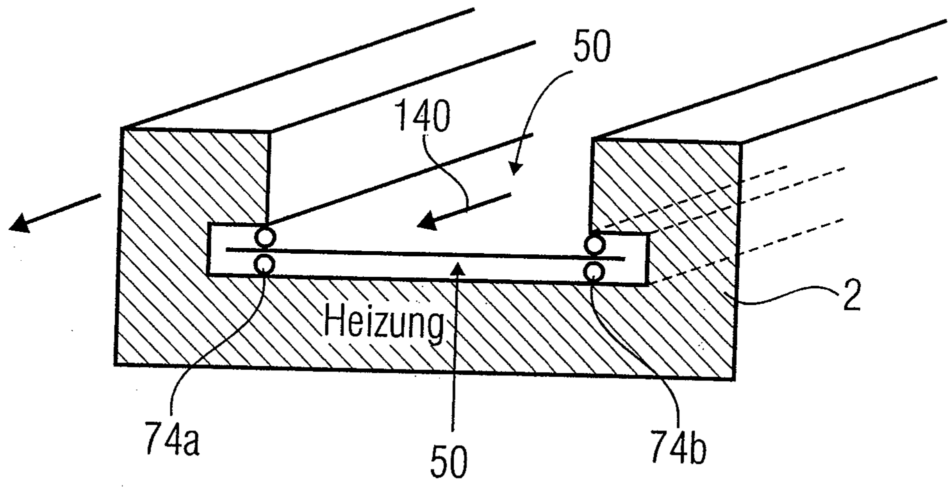


FIG 11

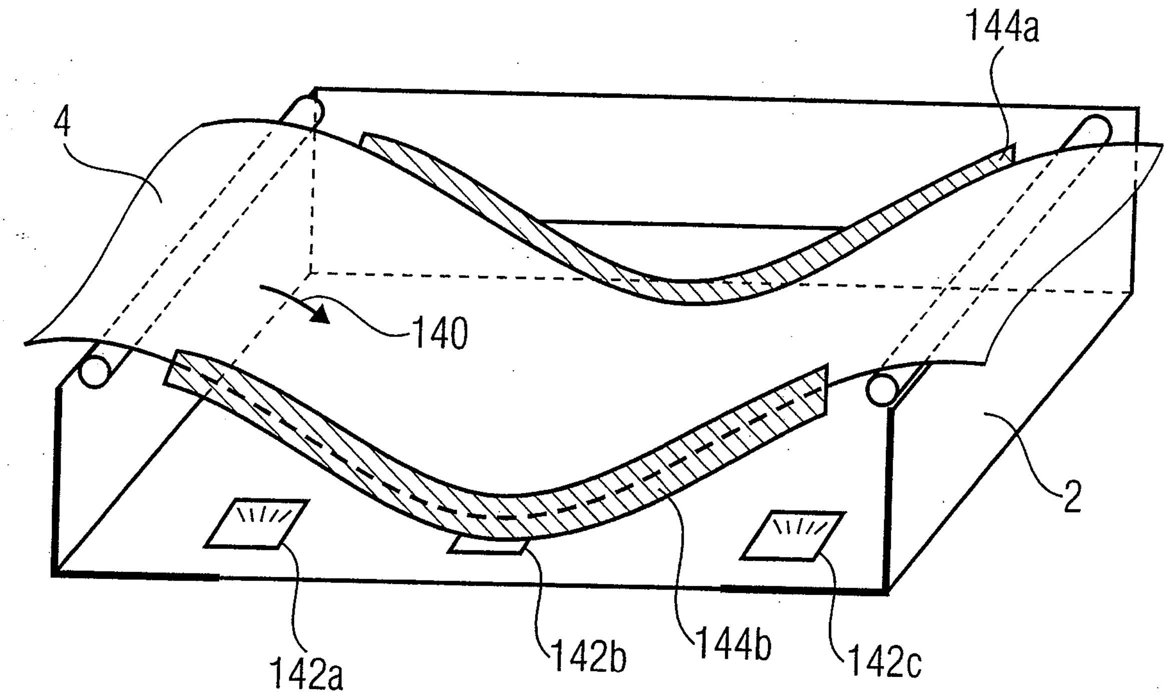

FIG 12

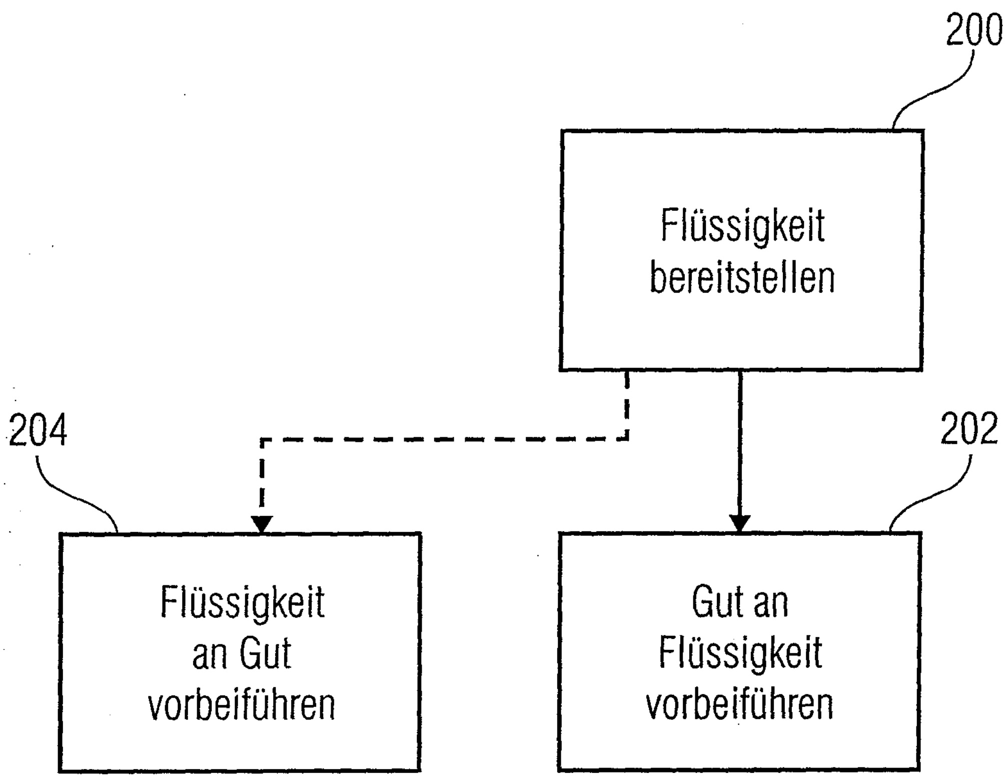
200
Flüssigkeit bereitstellen
204
202
Flüssigkeit an Gut vorbeiführen
Gut an Flüssigkeit vorbeiführen

FIG 13

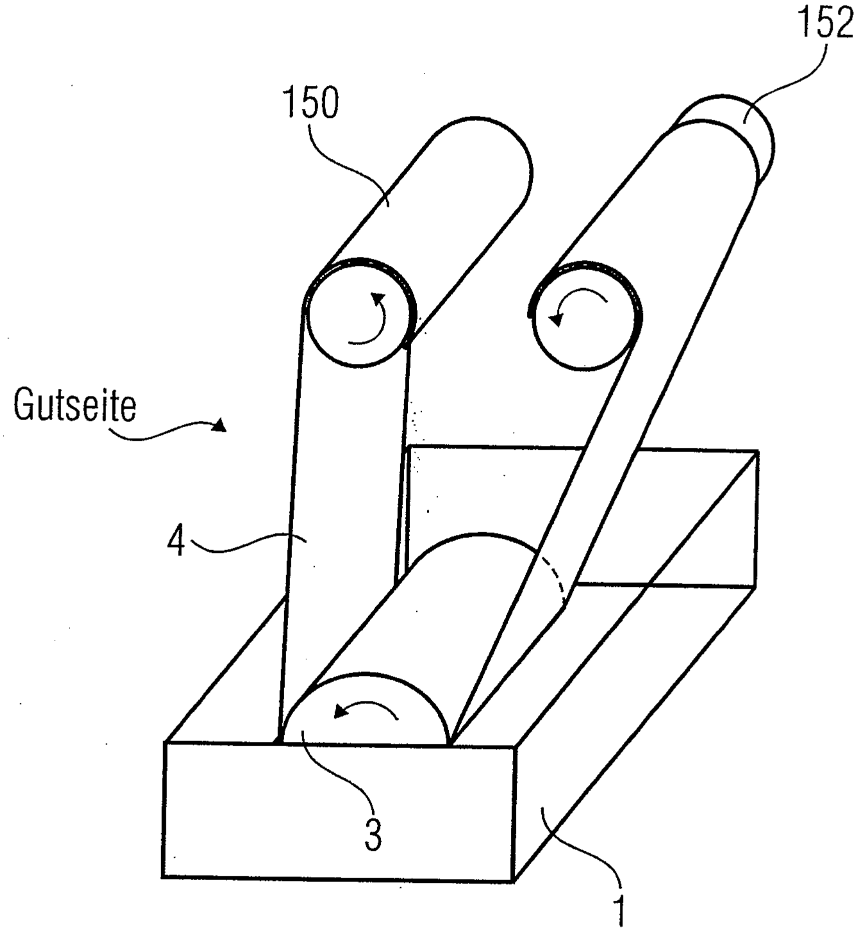

FIG 14A

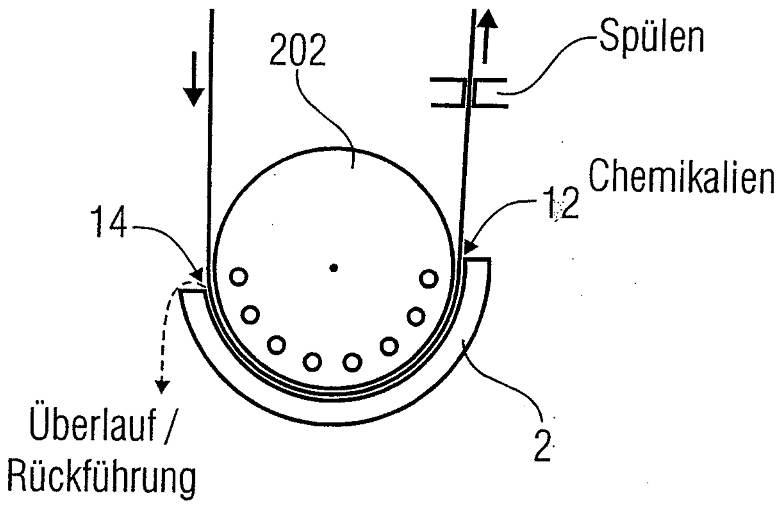


FIG 14B

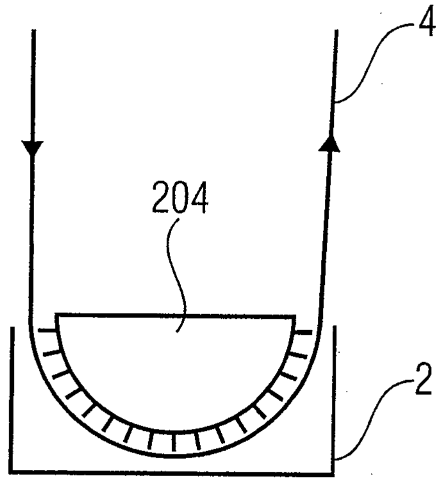

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- GB 1206106 A
- US 5795625 A
- US 3762190 A
- EP 0038084 A
- EP 0608192 A1
- US 3863600 A
- US 5298288 A